# EUROPÄISCHE PATENTANMELDUNG

(11) **EP 2 287 916 A2**
(43) Veröffentlichungstag der Anmeldung: **23.02.2011**
(21) Anmeldenummer: 10011997.3
(22) Anmeldetag: 26.08.2002
(51) Int. Cl.: H01L 31/0203, H01L 25/16

(54) **Verfahren zum Kontaktieren und Gehäusen von integrierten Schaltungen**

(30) Priorität: 24.08.2001 DE 10141571; 24.08.2001 DE 10141558; 06.06.2002 DE 10225373
(62) Teilanmeldung aus: 02796172.1
(71) Anmelder: Schott AG, 55122 Mainz (DE)
(72) Erfinder: Bieck, Florian, 13187 Berlin (DE); Leib, Jürgen, 91077 Neukirchen am Brand (DE)
(74) Vertreter: Schmidt, Oliver

(57) **Zusammenfassung**

Die Erfindung betrifft ein Verfahren zum Herstellen von elektrischen Kontaktverbindungen in einem Halbleiter-Wafer (1)), wobei der Wafer eine Oberseite, eine Unterseite, zumindest einen Anschlußkontakt (25) auf der Oberseite und auf der Oberseite (14) zumindest ein optisch aktives Bauelement umfasst, wobei
- der Wafer vor dem Zertrennen ausgedünnt wird, und wobei
- wenigstens ein Kontaktkanal in dem ausgedünnten Wafer erzeugt wird, welcher ein Loch (17) umfasst, welches
- von der Unterseite bis zum Anschlußkontakt (25) auf der Oberseite reicht, und wobei das Loch (17)
- mit einem Isolator zur elektrischen Isolation des Lochs (17) zum Wafer versehen und
- mit einem Metall beschichtet wird.

## Beschreibung

Die Erfindung betrifft ein Verfahren zum Herstellen von elektrischen Kontaktverbindungen für wenigsten ein in einem Trägermaterial integriertes Bauelement gemäß den Merkmalen des Anspruchs 1, einem Verfahren zur Montage mindestens eines Bauelements in ein Gehäuse gemäß den Merkmalen des Anspruchs 29 und eine Vorrichtung mit Kontaktverbindungen, welche wenigsten ein in einem Trägermaterial integriertes Bauelement umfasst nach den Merkmalen nach Anspruch 64, sowie ein Verfahren zur Herstellung von dreidimensional aufgebauten integrierten Schaltungen und eine integrierte Schaltungsanordnung gemäß den Ansprüchen 40 und 68.

Es sind Verfahren bekannt bei denen Bauelemente oder integrierte Schaltungen auf einem Halbleiterchip oder noch im Verbund einer Halbleiterscheibe bzw, Wafers mit einem Gehäuse und mit elektrischen Anschlusskontakten versehen werden. Findet die Montage des Chips bzw. der integrierten Schaltung und die Verbindung der Kontaktgebiete des Chips mit den nach außen geführten Kontakten des Gehäuses noch im Waferverbund statt, so wird ein solches Montageverfahren im allgemeinen als "Wafer Level Package-verfahren" bezeichnet.

Dem Stand der Technik sind eine Reihe solcher Verfahren zu entnehmen. Diese Verfahren gehen in der Regel davon aus, dass, wie es problemlos zum Beispiel bei Speicherchips der Fall ist, die Verbindungen zu den Kontaktgebieten auf den Chips bzw. bei den integrierten Schaltungen direkt hergestellt werden können.

Dabei bleibt allerdings unberücksichtigt, dass wie zum Beispiel bei Chips mit einem integrierten sensorischen oder optischen Bauelement, die optisch aktive Fläche im montierten Zustand, zum Beispiel auf einer Leiterplatte, frei liegen muss.

Aus der WO 99/40624 ist insoweit ein Verfahren bekannt, bei dem versucht wird, die oben dargestellte Problematik dadurch zu beheben, dass die beim aktiven Bauelement liegenden Anschlusskontakte von der aktiven Seite auf die ihr gegenüberliegende Unterseite des Wafers bzw. des Chips geführt werden. Die weitere Kontaktierung der nach unten geführten Anschlusskontakte kann dann auf bekannte Art und Weise erfolgen. Ein dazu ähnliches Verfahren ist außerdem in "Wafer Level Chip Scale Packaging; Benefits for Integrated Passive Devices", Clearfield, H.M.; Young, J.L.; Wijeyesekera, S.D.; Logan, E.A.; IEEE Transactions on Advanced Packaging, Vol, 23, No. 2, Seiten 247-251 beschrieben.

Das erwähnte Verfahren zeichnet sich dadurch aus, dass nach dem Aufbringen einer Glasabdeckung auf die optisch aktive Vorderseite eines Wafers entlang der Unterseite des Wafers Gräben erzeugt werden, die den Wafer in einzelne Chipbereiche unterteilen. Im Rahmen der Erzeugung der Gräben werden die auf der aktiven Seite des Wafers jeweils auf dem Übergangsbereich zwischen zwei Chips befindlichen Anschlusskontaktstellen geteilt und somit in den Gräben freigelegt. Zur vollständigen Gehäusung des Wafers bzw. der Chips wird nach dem Herstellen der Gräben über dieselben eine Glasscheibe geklebt, die in entsprechender Weise so eingeschnitten wird, dass die Gräben im Wafer als auch die Anschlusskontaktstellen wiederum frei zugänglich sind. Daran anschließend erfolgt ein Abscheiden von Kontaktbahnen in die erzeugten Gräben, wodurch ein Kontaktieren der Anschlusskontaktstellen und ein Verlegen der Kontaktstelle auf die Rückseite des gehäusten Chips erfolgen soll.

Das vorgestellte Verfahren führt zwar zu einem sogenannten Durchkontaktieren der Anschlusskontakte von der aktiven Vorderseite des Chips bzw. des Wafers auf die passive Rückseite, jedoch treten hierbei einige wesentliche Nachteile auf, so dass Chips, die nach dem besprochenen Verfahren hergestellt wurden, unverhältnismäßig teuer sind. Dies begründet sich unter anderem aus der Tatsache, dass die im bekannten Verfahren zu erzeugenden Gräben deutlich breiter sind als sie für gewöhnlich beim normalen Zerteilen bzw. Dicing eines Wafers anzutreffen wären. Im Ergebnis führt diese dazu, dass die Abstände zwischen den Chips oder den Integriertenschaltungen relativ groß sein müssen, so dass weniger Chips auf einem Wafer Platz haben. Bereits deshalb liefert das bekannte Verfahren nur eine relativ geringe Chip-Ausbeute aus einem Wafer oder Halbleiterscheibe. Darüber hinaus verläuft der Herstellungsprozess nach dem vorgestellten Verfahren auch relativ langsam. Dies hat zum einen insbesondere damit zu tun, dass die Gräben sequentiell eingeschliffen werden müssen und zum anderen dass beim Erzeugen der Gräben die sogenannte Dicing-Säge nur bei einem vergleichsweise langsamen Vorschub arbeiten kann, Davon abgesehen sind auch die einzusetzenden Dicing-Sägen sehr teuer. Eine wesentliche Problematik des Verfahrens nach der WO 99/40624 ist auch darin zu sehen, dass das Freilegen der Anschlusskontakte beim Aufschleifen der Gräben durch ein Zerteilen derselben erfolgt. Ein solches Zerteilen der Anschlusskontakte bedarf höchster Maßhaltigkeit, da es ansonsten zur Zerstörung von zumindest eines Teils des Kontakts kommen kann. Aber selbst wenn ein genaues Zerschneiden des Anschlusskontakts gelingt, ist es nicht einfach, mit den so freigelegten Anschlusskontakten eine Kontaktverbindung herzustellen. Die Ursachen hierfür liegen insbesondere darin begründet, dass das Kontaktieren nach dem Stand der Technik über ein Abscheiden von Kontaktbahnen auf den im Wafer schräg liegenden Wandungen der Gräben erfolgen soll, ein gleichmäßiges und damit zielgerichtetes Abscheiden jedoch nur senkrecht zur Abscheidungsrichtung möglich ist. Weitere Verfahren zum Durchkontaktieren von Chips werden auch in "Future Systems-on-Silicon LSI Chips", Koyanagi, M; Kurino, H; Lee, K.W.; Sakuma, K, IEEE Micro, July-August 1998, Seiten 17-22, WO98/52225 und DE 197 46 641 beschrieben. Diese sind jedoch für die Verpackung optischer Chips nicht geeignet.

Auf diesem Hintergrund liegt der vorliegenden Erfindung die Aufgabe zugrunde, die oben genannten Nachteile des Standes der Technik zu vermeiden, um auf diese Weise ein kostengünstigeres und einfacheres Verfahren zum Herstellen von elektrischen Kontaktverbindungen beim Verpacken insbesondere von optischen Chips bereitzustellen.

Gelöst wird diese Aufgabe auf höchst überraschende Weise bereits durch ein Verfahren zum Herstellen von elektrischen Kontaktverbindungen gemäß den Merkmalen des Anspruchs 1. Ferner wird nach der Erfindung auch ein Verfahren zur Montage mindestens eines Bauelements in ein Gehäuse gemäß den Merkmalen nach Anspruch 31 beansprucht und im unabhängigen Anspruch 66 eine Vorrichtung definiert, welche insbesondere nach einem der erfindungsgemäßen Verfahren herstellbar ist.

Vorteilhafte Weiterbildungen finden sich insbesondere in den jeweils zugeordneten Unteransprüchen.

Nach der Erfindung wird mit Vorteil ein Verfahren zum Herstellen von elektrischen Kontaktverbindungen für wenigstens ein in einem Trägermaterial integriertes Bauelement, wobei das Trägermaterial einen ersten Oberflächenbereich aufweist und wobei wenigstens ein Anschlusskontakt wenigstens teilweise im ersten Oberflächenbereich für jedes Bauelement angeordnet ist, vorgeschlagen, das sich insbesondere durch ein Aufbringen einer Abdeckung auf dem ersten Oberflächenbereich und einem Erzeugen wenigstens eines Kontaktkanals, der im Trägermaterial quer zum ersten Oberflächenbereich, beziehungsweise in einer Richtung im wesentlichen senkrecht zu diesem verläuft, auszeichnet, wobei zum Ausbilden wenigstens einer Kontaktstelle in einem bereitzustellenden zweiten Oberflächenbereich über die jeweiligen Kontaktkanäle wenigstens eine elektrische Kontaktverbindung von der Kontaktstelle zu wenigstens einem der Anschlusskontakte hergestellt wird.

Auf höchst vorteilhafte Weise kann so eine Kontaktstelle auf der zum Anschlusskontakt und damit auf der der aktiven Oberfläche abgewandten Seite des Trägermaterials eine mit dem Anschlusskontakt in elektrischer Verbindung stehende Kontaktstelle erzeugt werden. Wobei sowohl auf Gräben, die entlang des Trägermaterials verlaufen und auf eine seitliche um das Bauelement geführte Kontaktierung nach dem Stand der Technik verzichtet werden kann.

Nach einer vorteilhaften Weiterbildung des Verfahrens wird das Trägermaterial, in welchem die Bauelemente integriert sind bezogen auf die Anordnung der Bauelemente in zu definierende Chipbereiche aufgeteilt. Die für die Kontaktverbindung vorgesehenen Kontaktkanäle können nach der Erfindung auf verschiedene Art und Weise in das Trägermaterial eingebracht werden. Zum einen ist vorgesehen Kontaktkanäle im Trägermaterial derart anzuordnen, dass sie im wesentlichen in Nachbarschaft zu den Anschlusskontakten in das Trägermaterial eingebracht werden. Zum anderen sieht die Erfindung aber auch vor, die Kontaktkanäle in das Trägermaterial derart einzubringen, dass sie insbesondere vom zweiten Oberflächenbereich ausgehend im wesentlichen unmittelbar an die Anschlusskontakte anschließen. Letztere Variante bietet insbesondere den Vorteil, dass sich ein umverlegen der Anschlusskontakte auf dem ersten Oberflächenbereich erübrigt. Umverlegen heißt in diesem zusammenhang, dass auf dem ersten Oberflächenbereich eine Kontaktbahn erzeugt wird, die eine elektrische Verbindung zwischen dem Anschlusskontakt und dem Kontaktkanal herstellt. Ein Einbringen des Kontaktkanals neben dem Anschlusskontakt kann insbesondere dann von Vorteil sein, wenn sich zum Beispiel unterhalb des Anschlusskontaktes Teile von aktiven Bereichen des im Trägermaterial integrierten Bauelements befinden.

Nach einer weiteren vorteilhaften Ausführungsform der Erfindung werden die Kontaktkanäle oder zumindest Teile davon dort in das Trägermaterial eingebracht, wo in einem späteren Verfahrensschritt das Trägermaterial in verschiedene Chipbereiche zerschnitten wird. Da es nach der Erfindung möglich ist, durch einen Kontaktkanal mehr als nur eine elektrische Kontaktverbindung herzustellen, besteht so die Möglichkeit, auf einfache Art und Weise über die einzelnen Kontaktkanäle eine Kontaktverbindung zu mehreren Anschlusskontakten auf zum Beispiel verschiedenen Chipbereichen bzw, für verschiedene Bauelemente aufzubauen. Höchst vorteilhaft besteht nach der Erfindung die Möglichkeit die Kontaktkanäle auf unterschiedliche Weise zu erzeugen. Nach einer Ausführungsform der Erfindung wird beispielsweise der Kontaktkanal über ein Dotieren des Trägermaterials bereitgestellt. Hierbei werden vorzugsweise chemische Elemente der dritten und fünften Hauptgruppe des Periodensystems eingesetzt. Wobei als Verfahren zum Dotieren vorzugsweise das Ionenimplantieren oder thermische Defundieren der Elemente in das Trägermaterial zur Erzeugung der Kontaktkanäle zum Einsatz kommen.

Nach einer weiteren bevorzugten Ausführungsform der Erfindung umfasst das Erzeugen der Kontaktkanäle insbesondere das Bereitstellen von Lochöffnungen. Löcher bieten insbesondere den Vorteil, dass durch sie hindurch nicht nur eine Kontaktverbindung verlegt werden kann sondern selbstverständlich in Abhängigkeit von der Größe der Lochöffnung mehrere Kontaktbahnen in der Öffnung verlegbar sind, Mit Vorteil werden bei der Erzeugung, aber auch generell bei der Kontakkanalerzeugung, die Lochöffnungen bzw. die Kontaktkanäle lateral gegenüber dem Trägermaterial insbesondere elektrisch isoliert.

Im Rahmen der Erfindung können mit Vorteil zur Herstellung der Kontaktkanäle bzw, der Lochöffnungen verschiedenste Verfahren eingesetzt werden. So können die Kanäle zur Durchführung der Kontakte durch das Halbleitermaterial oder Trägermaterial vorzugsweise entweder mit Hilfe eines Trockenätzprozesses und/oder eines Nassätzprozesses erzeugt werden.

Der Trockenätzprozess umfasst nach der Erfindung regelmäßig ein fotolithographisches Strukturieren der zu bearbeitenden Oberfläche und ein anisotropes Trockenätzen, Vorzugsweise kommt der auf SF6-radikalen basierende "ASE(Advanced Silicon Etching)-Prozess" bzw. "Bosch-Prozess" zum Einsatz. Als Nassätzverfahren kommt das Ätzen vermittels KOH-Lauge in Betracht, Letzter Prozess bietet insbesondere Kostenvorteile.

Wie ausgeführt können im Rahmen der Erfindung die Kontaktkanäle, die einen kontaktierenden Durchgriff von einem Oberflächenbereich zum anderen Oberflächenbereich des Trägermaterials bzw. des Wafers erzeugen sollen, an unterschiedlichen Stellen im Trägermaterial oder im Chip oder im Wafer angeordnet werden. Dem Entsprechen kann es nach der Erfindung notwendig werden, dass zum Herstellen der elektrischen Kontaktverbindung bzw. Kontaktverbindungen die im Oberflächenbereich gelegenen Anschlusskontakte zu den jeweils zugeordneten Kontaktkanälen umverlegt werden. Das Umverlegen kann dabei durch übliche fotolithographische Strukturierung und entsprechendes Ätzen und dem Abscheiden von elektrisch leitfähigem Material erfolgen. Mit Vorteil sind nach der Erfindung die verschiedensten bekannten Abscheidungs- bzw. Beschichtungsverfahren einsetzbar. Dies sind z. B. das Sputtern, das CVD- und/oder PVC-Abscheiden und/oder das stromlose Abscheiden von vorzugsweise Aluminium, Kupfer oder Nickel.

Werden die erfindungsgemäßen Kontaktkanäle beispielsweise durch Lochöffnungen erzeugt, so können diese mit den erwähnten Verfahren auch mit elektrisch leitfähigen Materialien wie z. B. Aluminium und/oder Kupfer und/oder Nickel und/oder vergleichbaren Metallen aufgefüllt werden, um auf diese Weise eine Kontaktverbindung von dem ersten Oberflächenbereich zum zweiten Oberflächenbereich herzustellen. Über das Herstellen der von Kontaktkanälen werden gleichzeitig Kontaktstellen im zweiten Oberflächenbereich erzeugt. Wobei zum Herstellen insbesondere von externen, d. h. nach außen gerichtete Kontaktverbindung auf die Kontaktstelle wenigstens eine Lötperle aufgebracht werden können. Hierdurch wird auf einfache Art und Weise zum Beispiel ein Anschlusskontakt für eine Leiterplatte hergestellt.

Je nach den Anschlussstellen der besagten Leiterplatte oder ähnlichem kann mit Vorteil auch auf dem zweiten Oberflächenbereich ein Umverlegen der geschaffenen Kontaktstelle vorgesehen werden.

Insbesondere dann, wenn mehrere Leiterbahnen durch nur einen Kontaktkanal verlegt werden, bietet das erfindungsgemäße Verfahren die Möglichkeit zur gegenseitigen Isolierung der Kontakte den Kontaktkanal oder die mit Leiterbahnen versehenen Lochöffnungen im übrigen mit Isolierstoff auszufüllen. Werden später die so befüllten Lochöffnungen im Rahmen der Zerlegung des Wafers in einzelne Chips geteilt, so kann auf diese Weise bereits eine laterale Isolierung der vereinzelten Chips sichergestellt werden.

In vorteilhafter Weiterbildung des erfindungsgemäßen

Verfahrens wird die Abdeckung vorzugsweise in Form eines Glases oder eines vergleichbaren Kunststoffes bereitgestellt. Ein Glas oder ein Kunststoff bietet sich insbesondere dann an, wenn optisch aktive Bauelemente abzudecken sind, Die Verbindung zwischen der Abdeckung und dem ersten und/oder zweiten Oberflächenbereich erfolgt nach einer Ausführungsform der Erfindung mit Hilfe eines Haftvermittlers. Besondere mechanische oder optische Eigenschaften lassen aber sich auch beispielsweise mit einer Abdeckung erzielen, die einen Glas-Kunststoff-Verbundwerkstoff oder Schichtwerkstoff umfaßt.

Unter Oberflächenbereich ist nach der Erfindung eine im wesentlichen ebene Oberfläche oder ein Bereich des Trägermaterials zu verstehen, die oder der die Anschlusskontakte umfasst, die auf dem Halbleitermaterial des Trägermaterials angeordnet sind oder aus diesem herausragen können und die auf der u.a. eine Passivierungsschicht zumindest teilweise liegen kann, welche sich an das Substrat oder Halbleitermaterial des Trägermaterials anschließt.

Als Haftvermittler können vorzugsweise Epoxidharze und/oder Wachse und/oder Sol Gele verwendet werden. Der Einsatz von Wachs bietet insbesondere den Vorteil, dass die so geschaffene Verbindung ohne Zerstörung des Trägermaterials wieder gelöst werden kann. Das Herstellen einer Verbindung zwischen der Abdeckung aus vorzugsweise Glas und dem Trägermaterial auf der Basis eines Sol Gels erweist sich insbesondere insofern als vorteilhaft, als dass das Gel eine vergleichsweise große Transparenz besitzt und darüber hinaus eine sehr temperaturbeständige Verbindung mit insbesondere Glas eingeht. Da das Sol Gel selbst glasartig, sozusagen selbst Glas ist, hat es insbesondere in bezug auf Glas auch besonders gute Anpassungs- bzw. Übergangseigenschaften.

Eine weitere in diesem Zusammenhang stehende vorteilhafte Ausführungsform der Erfindung besteht auch darin, den Haftvermittler zum Verbinden der Abdeckung mit dem Trägermaterial durch ein sogenanntes Bonden zu ersetzen. Es kommen mit Vorteil vorzugsweise ein anodisches Bonden in Betracht. Im allgemeinen setzt das Bonden eine im wesentliche planare Oberfläche bzw, einen planaren Oberflächenbereich des Trägermaterials voraus. Von daher bietet es sich mit Vorteil an, falls die topographischen Unterschiede auf dem Trägermaterial oder Wafer zu groß sind, zunächst eine Oxidschicht auf der Waferoberfläche oder den Oberflächenbereichen des Trägermaterials abzuscheiden. Hierzu einsetzbare Verfahren sind zum Beispiel das "LTO(Low Temperature oxid)-" und das "TEOS(Tetra-Ethyl-Ortho-Silicat)-Verfahren". Des weiteren wird im Rahmen des Bondens der Abdeckung auf das Trägermaterial die abgeschiedene Oxidschicht mit Hilfe eines chemisch-mechanischen Polierprozesses derart planarisiert, dass die Mikro- und Makroplanarität für das Bonden bereitgestellt wird.

Abhängig davon, ob die Kontaktkanäle ausgehend von dem ersten Oberflächenbereich oder von dem zweiten bereitzustellenden Oberflächenbereich erzeugt werden variiert die Reihenfolge der Verfahrensschritte "Aufbringen einer Abdeckung" und "Erzeugen von wenigstens einem Kontaktkanals" nach der Erfindung.

Bei einer vorteilhaften Ausführungsvariante des erfindungsgemäßen Verfahrens wird bevor die Kontaktkanäle in das Trägermaterial eingebracht werden zunächst die Abdeckung auf den ersten Oberflächenbereich des Trägermaterials aufgebracht. Wobei sich im ersten Oberflächenbereich vorzugsweise die aktiven Bausteine befinden. Das Aufbringen der Abdeckung bietet den Vorteil, dass die im Trägermaterial befindlichen Bauelemente geschützt werden und die Anordnung zusätzlich an Stabilität gewinnt. Das Trägermaterial oder der Wafer oder die Halbleiterscheibe kann danach auf der Rückseite beispielsweise mechanisch durch einen Abschleifprozess aufgedünnt werden, ohne dabei seine mechanische Stabilität, die durch die Abdeckung gewährleistet wird, zu verlieren. Das Durchkontaktieren, d. h. das Erzeugen von wenigstens einem Kontaktkanal in dem ausgedünnten Trägermaterial, erfolgt dann nach einer der oben beschriebenen Möglichkeiten auf der Basis der Erzeugung von Dotierungskanälen oder mit Hilfe von mit leitfähigem Material versehenen Lochöffnungen. Es sei darauf verwiesen, dass insbesondere bei der vorhergehend beschriebenen Vorgehensweise die auf der aktiven Oberseite liegenden Anschlusskontakte direkt ausgehend vom bereitgestellten zweiten Oberflächenbereich über die jeweiligen Kontaktkanäle, sozusagen von hinten, durchkontaktiert werden können.

Eine weiteren Ausführungsvariante des erfindungsgemäßen Herstellungsprozesses von Kontaktkanälen bzw. Kontaktverbindungen besteht darin, dass das noch vor dem Aufbringen der Abdeckung und einem rückseitigen Ausdünnen des Trägermaterials oder Wafers ausgehend von der Vorderseite oder von dem ersten Oberflächenbereich Sackkanäle im Trägermaterial erzeugt werden. Die Bezeichnung Sackkanäle wurde deshalb gewählt, da diese Kanäle in der Regel noch nicht bis zum zweiten Oberflächenbereich hindurch reichen. Werden die Sackkanäle in Form von Sacklochöffnungen ausgebildet, d. h. in Form von Öffnungen deren Tiefe zunächst geringer ist als die Dicke des Trägermaterials, so wird auf die Sacklochwandungen im allgemeinen ein Isolator zur elektrischen Isolation des Lochs zum Trägermaterial aufgebracht und auf diese Kontaktbahnen verlegt oder abgeschieden und/oder danach die Sacklöcher mit einem leitfähigen Material ausgefüllt. Im Anschluss daran wird auf dem ersten Oberflächenbereich des Wafers oder Trägermaterials eine Abdeckung aufgebracht. Aufgrund der insbesondere stabilisierenden Wirkung der Abdeckung in bezug auf das Trägermaterial, ist es nun möglich ausgehend von der passiven Seite des Trägermaterials mit Hilfe eines vorzugsweise mechanischen Schleifprozesses das Trägermaterial auszudünnen. Das Ausdünnen erfolgt dabei solange bis zumindest im Bereich des Sacklochs, die darin eingebrachten Leiterbahnen oder leitfähigen Materialien freigelegt sind, so dass ein Durchkontaktieren des Trägermaterials oder Wafers oder Chip oder Substrat entsteht.

Eine entsprechende Vorgehensweise wird auch dann verfolgt, wenn die Kontaktkanäle auf der Basis von das Trägermaterial zunächst nicht durchdringenden Dotierkanälen erzeugt werden.

Wie bereits eingangs ausgeführt, liegt im Rahmen der Erfindung auch ein Verfahren zur Montage mindestens eines Bauelements in einem Gehäuse. Bei diesem Verfahren wird zunächst wenigstens ein Halbleiterbauelement in einem Trägermaterial, welches einen ersten Oberflächenbereich, der einem zweiten Oberflächenbereich gegenüberliegt umfasst, her-oder bereitgestellt, wobei wenigstens ein Anschlusskontakt wenigstens teilweise im ersten Oberflächenbereich für jede integrierte Schaltung angeordnet ist. Ferner wird unter Einsatz des oben vorgestellten Verfahrens ein mit einer ersten Abdeckung auf dem ersten Oberflächenbereich versehenes Trägermaterial mit wenigstens einer Kontaktstelle im zweiten Oberflächenbereich hergestellt und dann auf dem zweiten Oberflächenbereich eine zweite Abdeckung aufgebracht, Mit Hilfe der zweiten Abdeckung ist es mit Vorteil möglich, das Halbleiterbauelement gegen Beschädigung von außen zu schützen. Ferner begründet die zweite Abdeckung die Möglichkeit, dass falls die erste Abdeckung auf dem ersten Oberflächenbereich mit z. B. einem Wachs aufgebracht wurde, das diese für weitere Verarbeitungsschritte wieder abgenommen werden kann, ohne dass dabei der womöglich ausgedünnte Wafer oder Chip an Stabilität verlieren würde.

In vorteilhafter Weiterbildung des Erfindungsgegenstands werden in die zweite Abdeckung insbesondere dort Lochöffnungen eingebracht, wo sich die auf den zweiten Oberflächenbereich verlegten Anschlusskontakte des Halbleiterbauelements befinden. Es steht natürlich frei, die die Abdeckung durchdringenden Lochöffnungen noch vor dem eigentlichen aufbringen in die Abdeckungsschicht einzubringen. In vergleichbarer Art und Weise wie die Lochöffnungen im Trägermaterial können auch die Abdeckungsöffnungen mit leitfähigem Material wie z. B. Aluminium, Kupfer oder Nickel ausgefüllt werden, um auf diese Weise eine Verbindung der verlegten Anschlusskontakte nach außen herzustellen.

Mit Vorteil ist es erfindungsgemäß natürlich auch möglich, durch geeignete Maßnahmen, die auf dem zweiten Oberflächenbereich befindlichen Kontaktstellen so zu verlegen, dass eine Anpassung an die Lage der Lochöffnungen durch die zweite Abdeckung erfolgt. In entsprechender Weise können die durch die Abdeckungsöffnungen verlegten Kontaktstellen auf der freiliegenden Seite der Abdeckung weiterverlegt werden.

Ferner betrifft eine Weiterentwicklung des erfindungsgemäßen Verfahrens soweit das Trägermaterial oder die Halbleiterscheibe mehrere Bauelemente oder integrierte Schaltungen umfasst das Ausbilden von Trenngräben zwischen den Bauelementen oder integrierten Schaltungen. Diese Gräben dienen vorzugsweise zur elektrischen Entkopplung oder Isolierung der einzelnen Bauelementen auf den verschiedenen Chipbereichen. Hierzu können die geschaffenen Gräben ferner mit einem Isolierstoff aufgefüllt werden. Ein möglicher Isolierstoff ist z. B. Epoxidharz oder BCB (Benzocyclobuten). Die Trenngräben werden im Rahmen des Verfahrens auf dem Wafer oder auf der Halbleiterscheibe derart angeordnet, dass über ein im wesentlichen symmetrisches Zerteilen der Trenngräben der Wafer in verschiedene im wesentlichen gleich große Chipbereiche zerlegt wird. Höchst Vorteilhaft können auf diese Weise die auf den Chips liegenden Bauelemente auch lateral abgedichtet oder nach außen isoliert werden.

Wie bereits aus der obigen Beschreibung ersichtlich kann sowohl das Verlegen der Anschlusskontakte als auch die Montage der Bauelemente in ein Gehäuse nach der Erfindung im Waferverbund stattfinden.

Es liegt weiterhin im Rahmen der Erfindung, ein Verfahren zur Herstellung integrierter Schaltungen anzugeben, das auch insbesondere dazu geeignet ist, mehrschichtig aufgebaute, integrierte Schaltungen herzustellen. Das Verfahren ist, insbesondere auch zur Herstellung mehrschichtiger integrierter Schaltungen oder zur Montage erfindungsgemäß hergestellter Schaltungen auf geeigneten Unterlagen geeignet.

Zur Miniaturisierung von elektronischen Bauteilen werden vielfach integrierte Halbeiterschaltungen verwendet, welche allein oder zusammen mit anderen Schaltungsbestandteilen oder anderen Schaltungen auf eigenen Halbleitersubstraten oder Halbleiterwafern aufgebracht sind. Ein derartiges Halbleitersubstrat mit einem elektronischen Bauteil oder vorzugsweise zumindest einem elektronischen Schaltungebestandteil soll im nachfolgenden vereinfacht als Chip bezeichnet werden. Insbesondere auf den Gebieten der Optoelektronik und der Mikro-opto-elektromechanischen Systeme ("MOEMS") ergeben sich vielfältige Anwendungsmöglichkeiten für derartige Schaltungsanordnungen. So können solche optischen oder sensorischen Bauteile und nichtoptische Bauteile übereinandergestapelt werden. Insbesondere ergeben sich vielfältige Möglichkeiten durch Komnbination von CMOS-und CCD-Chips.

Ferner wird für Logik- und Prozessoranwendungen zumeist CMOS-Technologie verwendet. Mit solchen CMOS-Chips lassen sich jedoch optische oder sensorische Bauteile nur schlecht realisieren. Durch die Verbindung eines optischen CCD-Chips mit einem CMOS-Chip kann beispielsweise eine hochintegrierte Speicherschaltung vorteilhaft in die Bildaufnahmeeinheit integriert werden. Ebenso kann der CCD-Chip mit einem Prozessorbaustein zur Datenkompression kombiniert werden, so daß in der weiteren Elektronik des Gerätes nachfolgend nur noch komprimierte Daten verarbeitet werden müssen.

Aus dem Stand der Technik, wie beispielsweise in US 6,171,887 beschrieben, sind eine Reihe von Verfahren zur Montage von elektronischen Bausteinen auf zugeordneten Unterlagen bekannt. Bei diesen Verfahren wird der Chip mit seiner aktiven Seite zur Unterlage zeigend montiert. Bei dem in US 6,171,887 offenbarten Verfahren werden auf den Kontaktflächen des Chips Lötperlen aufgebracht. Diese Seite des Chips wird daraufhin mit einer isolierenden Schutzschicht abgedeckt, die so dick ist, daß auch die Lötperlen vollständig bedeckt sind. Die Schutzschicht wird in einem weiteren Schritt abgeschliffen und poliert, bis die Kontakte teilweise freigelegt sind. Der so behandelte Chip wird dann mittels Aufschmelzen der Elektroden und des Schutzfilms mit der Unterlage verbunden, wobei die Elektroden zugehörige Kontaktflächen der Unterlage kontaktieren. Dieses Verfahren läßt sich zur Herstellung von gestapelten Bauteilen, welche aufgrund deren eigenständiger Handhabbarkeit nachfolgend auch als elektronische Bausteine bezeichnet werden, mit optoelektronischen Elementen im allgemeinen nicht verwenden, weil die optisch, bzw. sensorisch aktive Seite von der Unterlage oder dem mit dem optischen Bauteil verbundenen Element abgedeckt werden würde.

Die Erfindung sieht dementsprechend ein Verfahren zur Herstellung integrierter Schaltungen vor, bei welchem ein Wafer verwendet wird, welcher ein Substrat, zumindest einen Anschlußkontakt und auf einer ersten Seite eine die Schaltkreise eines Chips umfassende aktive Schicht aufweist. Das Verfahren umfaßt die Schritte:
1. Befestigen einer transparenten Abdeckung auf der ersten Seite des Wafers,
2. Ausdünnen des Wafers auf einer der Seite, welche die aktive Schicht aufweist, gegenüberliegenden Seite,
3. Einfügen von zumindest einem sich im wesentlichen senkrecht zur Oberfläche der ersten Seite erstreckenden, leitenden Kanals von einer zweiten Seite des Wafers her, welche der Seite mit der aktiven Schicht gegenüberliegt in den Wafer, und
   Herstellen eines elektrischen Kontakts zwischen zumindest einem Anschluß der Schaltkreise des Wafers und dem leitenden Kanal.

Dieses Verfahren kann auf diese Weise auch vorteilhaft zur Herstellung mehrschichtig aufgebauter integrierter Schaltungen mit zumindest zwei Chips weitergebildet werden, die jeweils zumindest einen Anschlußkontakt und auf einer ersten Seite eine die Schaltkreise des Chip umfassende aktive Schicht aufweisen. Das Verfahren sieht dazu vor, auf einer Seite eines ersten der zumindest zwei Chips eine Abdeckung zu befestigen. Um einen Kontakt von einer Seite des Chip zur anderen Seite herzustellen, wird ein leitender Kanal in das Substrat eingebracht, der sich in einer Richtung im wesentlichen senkrecht zur Oberfläche des Chip, bzw. zur ersten Seite des Chip erstreckt. Auf der anderen Seite des Chip wird eine Kontaktfläche hergestellt, die mit dem leitenden Kanal elektrisch verbunden ist. Ebenso wird zumindest ein Anschluß der Schaltkreise des ersten Chip auf der ersten Seite mit dem leitenden Kanal verbunden. Anschließend werden der erste und zumindest ein weiterer Chip derart aufeinander befestigt, daß zwischen dem elektrisch leitenden Kanal des ersten Chip und zumindest einer korrespondierenden Anschlußfläche des anderen Chip ein elektrischer Kontakt hergestellt wird.

Unter Bezugnahme auf die deutsche Patentanmeldung mit dem Titel "Verfahren zum Kontaktieren und Gehäusen von integrierten Schaltungen" wird deren Gegenstand in die vorliegende Erfindung mit einbezogen. Dieser Verweis gilt insbesondere für das Herstellen eines leitenden Kanals durch einen Wafer oder Chip.

Der zumindest eine leitender Kanal kann auf verschiedene Weise erzeugt werden. Nach einer Ausführungsform des Verfahrens wird der Kanal durch Einfügen eines Loches erzeugt, welches anschließend mit einem leitenden Material, wie etwa einem Metall oder einem leitenden Epoxid aufgefüllt wird.

Es ist ebenso möglich, den Kanal durch Einfügen einer geeigneten Dotierung zu erzeugen. Das Dotieren kann beispielsweise mit Ionenimplantation oder thermischer Diffusion durchgeführt werden.

Gemäß einer vorteilhaften Weiterbildung des Verfahrens wird der erste Chip auf der zweiten Seite ausgedünnt, die der ersten, die aktive Schicht aufweisenden Seite gegenüberliegt. Wenn das Loch mit einer Tiefe erzeugt wird, die zunächst geringer als die Dicke des Substrats ist, so bildet sich ein Sackloch. Ebenso reicht die Eindringtiefe der Dotierung unter Umständen nicht, um einen von einer Seite zur anderen Seite des Substrats reichenden leitenden Kanal herzustellen. Gemäß der Weiterbildung wird durch den Schritt des Ausdünnens die Dicke des Substrats zumindest im Bereich des Lochs oder der Dotierung geringer als die Tiefe des Lochs, bzw. der Eindringtiefe der dotierenden Atome gemacht, so daß eine Durchkontaktierung durch das Substrat hindurch entsteht. Die Löcher werden dabei vorzugsweise mittels Ätzen hergestellt und stellen somit Ätzgruben im Substrat dar.

Merkmale weiterer vorteilhafter Ausgestaltungen des erfindungsgemäßen Verfahrens finden sich auch in den Unteransprüchen.

Das erfindungsgemäße Verfahren gestattet es, einen Chip mit einer Unterlage, insbesondere einem weiteren Chip so zu verbinden, daß die Unterlage der Rückseite des Chips zugewandt ist und zusätzlich elektrische Verbindungen der Oberseite oder aktiven Seite des Chips mit der Unterlage hergestellt werden. Hierzu wird der Chip mit leitenden Kanälen versehen, die sich von der Oberseite zur Unterseite erstrecken. Die Kanäle werden mit einer leitenden Schicht versehen oder mit einem Leiter aufgefüllt, um eine Durchkontaktierung herzustellen.

Alternativ kann ein Oberflächenbereich des Chip dotiert werden, so daß sich durch die Dotierung ein leitender Bereich bildet, der sich bis auf die gegenüberliegende Seite erstrecken kann und so einen leitenden Kanal bildet, Die mit Hilfe der leitende Kanäle durch den Chip hindurchgeführten Kontakte können dann mit Lötperlen versehen werden, mit denen der Chip mit der Unterlage verbunden wird. Die Verbindung der Chips kann beispielsweise in ähnlicher Weise wie in US 6,171,887 beschrieben durchgeführt werden. Alternativ können die Kontakte selbstverständlich ebenso auf dem anderen Chip oder auf beiden aufgebracht werden.

Die Kanäle, die zur Durchführung der Kontakte durch das Halbleitermaterial dienen, können unter anderem mittels eines Trockenätzverfahrens hergestellt werden. Geeignet hierfür ist insbesondere ein anisotropes Trockenätzverfahren wie zum Beispiel der auf SF₆-Radikalen basierende "ASE-Prozeß". Eine kostengünstige Alternative ist hierbei das anisotrope Ätzen mit KOH-Lauge, welche sich bei Si-Wafern in (100)-Orientierung anbietet. Selbstverständlich können auch Kombinationen der oben genannten Verfahren zur Erzeugung der Kanäle zur Anwendung kommen. Zur Erzeugung von Trenngräben können ferner ebenfalls diese Verfahren angewendet werden, wobei die Trenngräben beispielsweise in einem Schritt zusammen mit den Kanälen geätzt werden können. Ebenso ist es unter anderem aber auch möglich, für das Ätzen der Trenngräben und das Ätzen von Kanälen jeweils ein anderes der oben genannten Verfahren oder eine andere Kombination dieser Verfahren zu benutzen.

Der mit dem optischen oder sensorischen Chip zu verbindende Baustein benötigt seinerseits Durchkontaktierungen für eine Verbindung mit der Platine oder mit einem weiteren Chip. Dieser Chip wird daher ähnlich präpariert wie der obenliegende optische oder sensorische Chip, wobei der Baustein zwei Sätze von Kontaktflächen aufweist. Ein Satz von Kontaktflächen paßt in Orientierung und Position mit den korrespondierenden Durchkontaktierungen des optischen Chips zusammen, während der zweite Satz zum Herstellen von Durchkontaktierungen zur Platine oder dem nächsten darunterliegenden Baustein dient.

Während der Verfahrensschritte gemäß der Erfindung befinden sich die Bausteine bevorzugt noch im Waferverband, sind also während der Herstellung noch nicht vom Wafer abgetrennt.

Nach einer bevorzugten Ausführung der Erfindung wird der Wafer auf der optischen Seite mit einer transparenten Abdeckung, etwa einer dünnen Glasscheibe verklebt. Die Bausteine auf dem Wafer werden dadurch geschützt und die Anordnung gewinnt zusätzliche Stabilität. Als Kleber kann ein geeignetes Epoxidharz verwendet werden. Der Wafer kann danach auf der Rückseite mechanisch durch einen Schleifprozeß ausgedünnt werden, wobei die mechanische Stabilität weiterhin durch die transparente Abdeckung gewährleistet wird. Die Durchkontaktierungen können dabei auf zwei verschiedene Weisen hergestellt werden. In einer ersten Variante des Verfahrens wird die Oberseite des optischen Chips photolithographisch strukturiert und die Ätzgruben eingebracht. Die leitenden Kanäle befinden sich in dieser Variante neben den Kontaktflächen oder Bondpads zum Anschluß des Chips. Die Ätzgruben werden danach mit einem Leiter aufgefüllt und eine Leiterbahn von der Ätzgrube zum Bondpad aufgebracht. Danach kann die transparente Abdeckung aufgebracht werden und der Wafer wird daraufhin auf der Rückseite solange ausgedünnt, bis die leitenden Auffüllungen der Ätzgruben auf der Oberfläche der Rückseite hervortreten.

Gemäß einer anderen Alternative wird die Abdeckung vorher aufgebracht und der Wafer ausgedünnt. Die photolithographische Strukturierung und das Ätzen erfolgt in diesem Fall von der Unterseite des Chips, wobei sich die Ätzgruben unterhalb der auf der Oberseite befindlichen Bondpads befinden und so lange geätzt wird, bis die Bondpads freigelegt werden.

In ähnlicher Weise werden die nichtoptischen Chips vorbereitet, wobei das Verfahren auch hier im Waferverband erfolgen kann. Die nichtoptischen Chips, auf denen die optischen Chips aufgebracht werden, weisen zunächst wie oben erwähnt zwei Sätze von Kontaktflächen oder Bondpads auf, die zur Durchkontaktierung, bzw. zum Anschluß des optischen Chips oder eines darüberliegenden Chips dienen. Der Wafer mit den nichtoptischen Chips wird ebenfalls ausgedünnt, jedoch ohne die Stabilität zu gefährden. Der ausgedünnte Wafer wird danach photolithographisch strukturiert und an den für die Durchkontaktierung vorgesehenen Stellen durchgeätzt. Diese Verfahrensschritte des Strukturierens und Ätzens können wie bei den optischen Chips sowohl von der Oberseite oder aktiven Seite als auch von der Unterseite ausgehend durchgeführt werden. Die durch die Ätzgruben gebildeten Kanäle durch den Wafer werden danach metallisiert oder mit einem Leiter aufgefüllt. Für den Fall, daß sich die Kanäle neben den zugeordneten Kontaktflächen befinden, werden die Kontaktflächen mit Leiterbahnen mit den aufgefüllten Kanälen verbunden. Die Kontaktflächen werden beidseitig mit Lötperlen versehen. Eventuell kann auf das Aufbringen dieser Kontakte, die für den Anschluß des optischen Chips oder darüberliegenden Chips vorgesehen sind, verzichtet werden, sofern sich bereits auf den zugehörigen Kontakte des darüberliegenden Chips solche aufschmelzbaren Kontakte befinden.

Die auf diese Weise vorbereiteten Chips können dann miteinander verbunden werden. Falls die Chips auf den Wafern in gleicher Weise angeordnet sind, so daß die korrespondierenden Kontakte beim Aufeinanderlegen der Wafer übereinander zu liegen kommen, so kann das Verbinden der Chips im Waferverband durchgeführt werden. Anderenfalls wird der Wafer mit den kleineren Chips mittels einer Dicing-Säge zersägt und die Chips danach auf den anderen Wafer aufgesetzt. Mittels Aufschmelzens oder Reflow des Lots der Lötperlen werden dann die beiden Wafer bzw. die Chips mit dem Wafer unter Herstellung von Kontaktierungen zwischen den Chips verbunden. Zum Verbinden der Wafre, bzw. Chips untereinander wird bevorzugt ein hochschmelzendes Lot verwendet, welches eine höhere Schmelztemperatur als das zum Verbinden mit der Platine verwendete Lot besitzt. Dadurch wird verhindert, daß sich die Verbindungen der Chips des Chipstapel untereinander beim Verbinden mit der Platine wieder lösen. Für die Verbindung der Chips untereinander kann so beispielsweise reines Zinn verwendet werden. Die Chips werden in einem abschließenden Schritt mit einer Dicing-Säge abgetrennt.

Während der Vorbereitung der Chips auf den Wafern können diese nach Aufbringen der transparenten Abdeckung mit verschiedenen Wafer-Level Verpackungsverfahren eingepackt werden.

Das erfindungsgemäße Verfahren ermöglicht auch eine Verbindung von mehr als zwei Schichten von Bauelementen oder Chips, wobei die entsprechend vorbereiteten Teile entweder gleichzeitig oder nacheinander miteinander verbunden werden.

Werden die Elemente der mehrschichtigen integrierten Halbleiteranordnung gemäß eines Ausführungsbeispiels sukzessive aufeinander befestigt, so gestattet es die dem jeweils zuletzt angefügten Wafer oder Chip durch den Verbund der Elemente zusätzlich verliehene mechanische Stabilität, daß er vergleichsweise weiter ausgedünnt werden kann. Dieses Ausführungsbeispiel basiert daher auf einem sukzessiven aufeinander Befestigen mit anschließendem Ausdünnen der Wafer oder Chips. Dies hat zur Folge, daß die Löcher oder A̅tzgruben in den Chips durch ein vergleichsweise dünneres Substrat geätzt werden müssen und dadurch im Durchmesser kleiner bleiben.

Es ist ferner zu beachten, daß es sich bei dem obersten Chip des mit dem Verfahren hergestellten Stapels nicht um einen optischen Chip handeln muß. Vielmehr lassen sich mit der Erfindung beliebige Halbleiterbausteine miteinander zu kompakten dreidimensionalen Stapeln verbinden. Das Verfahren ist zum Beispiel zum Stapeln von Speicherbausteinen besonders geeignet, die ohne isolierende Zwischenschicht zwischen den Chips miteinander verbunden werden können. Ebenso können auch integrierte Schaltungen auf unterschiedlichen Substraten, wie Ge, Si und GaAs vorteilhaft raumsparend miteinander kombiniert werden. Ebenso sind mit dem Verfahren verschiedenste sensorische Chips mit weiteren Bausteinen kombinierbar. Die sensorischen Chips können beispielsweise Strahlungs- Druck- Temperatur- oder Feuchtigkeitssensoren aufweisen. Ebenfalls sind chemisch sensitive Sensoren verwendbar, die auf bestimmte Gase oder Flüssigkeitsbestandteile ansprechen.

Eine transparente Abdeckung kann auch in vorteilhafter Weise strukturiert sein. So lassen sich in die Abdeckung beispielsweise optische Elemente, wie Prismen, Gitter oder optische Filter integrieren.

Für den Fall, daß keine transparenten Abdeckungen auf dem obersten Chip vorhanden sein sollen oder müssen, beispielsweise, wenn es sich beim obersten Chip nich um einen optischen Chip handelt, läßt sich der Chip auch mittels eines ablösbaren Wachses auf einer Unterlage befestigen, die während der Herstellungsprozesses, insbesondere während des Ausdünnens zusätzliche Festigkeit verleiht. Alternativ kann die Abdeckung auch beispielsweise mittels eines Epoxidharzes während des Herstellungsprozesses fixiert werden, das unter Einwirkung von UV-Licht wieder ablösbar wird.

Entsprechend den erfindungsgemäßen Verfahren liegt im Rahmen der Erfindung auch eine mehrschichtige integrierte Schaltungsanordnung, die zumindest zwei übereinander angeordnete Chips umfaßt, welche jeweils ein Substrat, zumindest einen Anschlußkontakt und auf einer Seite eine die Schaltkreise des Chip umfassende aktive Schicht aufweisen. Zumindest einer der Chips der Schaltungsanordnung weist vorteilhafterweise einen leitenden Kanal auf, wobei elektrischer Kontakte zwischen zumindest einem Anschluß der Schaltkreise des Chips, der den Kanal aufweist und dem leitenden Kanal einerseits und einer Anschlußfläche des weiteren Chip mit dem leitenden Material andererseits bestehen.

Die fertig zusammengesetzte mehrschichtige integrierte Halbleiteranordnung kann zusätzlich mit einer schützenden Gehäusung versehen werden. Eine solche mehrschichtige integrierte Schaltungsanordnung, die mit dem erfindungsgemäßen Verfahren hergestellt und im Verlauf der Herstellung mit einer vorteilhaften schützenden Gehäusung versehen wurde, stellt ein wie in Anspruch 79 beanspruchtes gehäustes Multipackage dar. Ein gehäustes Multipackage umfaßt so ebenfalls zumindest zwei übereinander angeordnete Chips, die auf einer Seite jeweils zumindest einen Anschlußkontakt und eine die Schaltkreise des Chip umfassende aktive Schicht aufweisen. Die so angeordneten Chips sind vorteilhafterweise zumindest teilweise von einem Gehäuse umschlossen. Höchst vorteilhaft weist zumindest einer der Chips des einen leitenden Kanal auf, wobei ebenfalls ein elektrischer Kontakt zwischen zumindest einem Anschluß der Schaltkreise des Chip, der den Kanal aufweist und dem leitenden Kanal einerseits und einer Anschlußfläche eines weiteren Chip mit dem leitenden Kanal andererseits besteht.

Entsprechend den erfindungsgemäßen Verfahren liegt im Rahmen der Erfindung auch eine Vorrichtung, die vorzugsweise ein sensorisch oder optisch oder ein entsprechendes nach außen wirkendes aktives Bauelement beinhaltet, wobei das Bauelement über zwei Abdeckungen auf dessen erster und zweiter Oberfläche und einer lateralen Isolierung nach außen hin isoliert bzw. geschützt ist.

Die vorliegende Erfindung wird nachfolgend anhand einzelner Ausführungsbeispiele im einzelnen beschrieben. Hierzu wird auf die beigefügten Zeichnungen Bezug genommen, wobei sich in den einzelnen Zeichnungen gleiche Bezugszeichen auf gleiche Teile beziehen.

Es zeigen:
- Figs.1 1A bis 1E: den Verlauf einer ersten Variante des erfindungsgemäßen Verfahrens zum Herstellen von elektrischen Kontaktverbindungen anhand verschiedener Querschnittsansichten eines Halbleiterchips oder Halbleiterscheibe.
- Figs. 2A bis 2C: eine zu den Figs 1 entsprechende Darstellung von möglichen weiteren Verfahrensschritten im Zusammenhang mit den erfindungsgemäßen Verfahren nach Fig. 1.
- Figs. 3A bis 3D: die Verfahrensschritte gemäß einer weiteren Ausführungsform des erfindungsgemäßen Verfahrens,
- Figs. 4A bis 4D: eine Variante des anhand der Figuren 3A bis 3D dargestellten Verfahrens mit einer Redistribution der Anschlüsse
- Figs. 5A bis 5C: eine zu den vorhergehenden Darstellungen entsprechende Querschnittsansicht einer weiteren Variante des erfindungsgemäßen Kontaktverbindungsverfahrens
- Figs. 6A und 6B: ein weiteres Ausführungsbeispiel der Erfindung bei der zwischen den Chipbereichen auf dem Wafer von der passiven Seite aus Trenngräben eingebracht wurden.
- Figs. 7A und 7B: eine Ausführungsform nach der Erfindung bei der entlang der Trennlinien zwischen den Chips auf dem Wafer Durchkontakierungsstellen für wenigstens zwei Bondpads erzeugt wurden.
- Figs. 8A bis 8C: Querschnittsansichten verschiedener Ausführungsformen von Chips für einen Chipstapel, die sich im dreidimensionalen, mehrschichtigen elektronischen Baustein unter dem obersten Chip befinden,
- Figs 9A bis 9D: anhand von Querschnittsansichten die Schritte einesAusführungsbeispiels und insbesondere wie der oberste Chip mit einem darunterliegenden Chip zu einem Chipstapel zusammengefügt werden kann,
- Figs. 10A bis 10E: anhand schematischer Querschnittsansichten ein weiteres Ausführungsbeispiel des erfindungsgemäßen Verfahrens,
- Figs. 11A bis 11C: Querschnittsansichten von Ausführungsformen fertig zusammengesetzter mehrschichtiger elektronischer Bausteine,
- Fig. 12: eine Querschnittsansicht einer weiteren Ausführungsform.

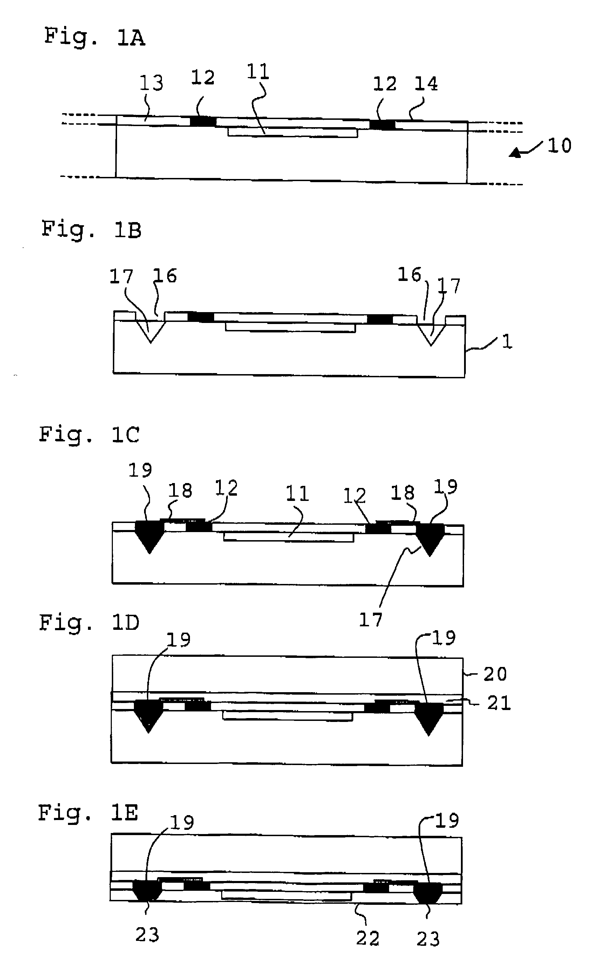

Zur nachfolgenden detaillierten Beschreibung bevorzugter Auführungsformen wird zunächst auf ein in den Figuren 1A bis 1E dargestelltes Ausführungsbeispiel Bezug genommen. Die Figuren 1A bis 1E zeigen die Verfahrensschritte einer ersten Variante des erfindungsgemäßen Verfahrens zum Herstellen von elektrischen Kontaktverbindungen anhand verschiedener Querschnittsansichten eines Wafers bzw. Halbleiterscheibe 10 oder Halbleiterchips 10. Es soll sich hierbei vorzugsweise um einen sensorischen Chip und hierbei beispielsweise um einen optischen oder durckempfindlichen oder feuchtigkeitsempfindlichen etc. Chip handeln, bei dem insbesondere von Wichtigkeit ist, daas nach einem Kontaktieren oder Befestigen oder Kontaktverbinden des Chips auf z.B. einem Board oder mit sonstigen Geräten oder Einrichtungen, die aktive sensorische Seite frei liegen kann oder soll. Die Verfahrensschritte der Figuren 1A bis 1E zeigen anhand von Querschnittsansichten hierbei auch Verfahrensschritte, die zur Vorbereitung eines Chips zum Zusammenfügen zu einem dreidimensionalen Chipstapel geeignet sind.

Der optische Chip oder sensorische Chip nach Fig. 1A ist im Waferverbund 10 angeordnet und besteht entsprechend der Halbleiterscheibe 10 aus einem Substrat 1, an dessen Oberseite 14 sich eine optisch aktive Schicht 11, wie etwa die Sensorschicht eines CCD-Chips befindet. Die Oberseite 14 des Chip ist zusätzlich mit eine Passivierungsschicht 13 überdeckt. Auf der Oberfläche befinden sich außerdem Kontaktierungsflächen oder Bondpads 12, die zum Anschluß des Chip verwendet werden und über Leiterbahnen mit der optisch sensitiven Schicht 11 verbunden sind.

Nach dem Bereitstellen des Wafers wird zunächst in einem nächsten Schritt des Verfahrens, wie anhand von Figur 1B gezeigt ist, an den für die Durchkontaktierungen vorgesehenen Stellen Öffnungen 16 in die Passivierungsschicht gemacht oder eingebracht und das Substrat freigelegt. Dieser Schritt kann beispielsweise durch photolithographisches Strukturieren und nachfolgendes Ionenstrahlätzen durchgeführt werden.

In einer nachfolgenden Ätzprozedur werden Ätzgruben bzw. Sacklochöffnungen 17 in das Substrat geätzt, wobei die Passivierungsschicht 13 das Substrat außerhalb der Öffnungen 16 vor einem Anätzen schützt. Zur weiteren Verarbeitung reicht für die Sacklochöffnungen ein Tiefe im Bereich von ca. 50 bis 200µm bei einer Gesamtstärke des Substrats von ca. 500µm. Für die Herstellung der Ätzgruben ist unter anderem anisotropes Ätzen eines Si(100)-Substrats mit KOH geeignet, wobei sich Ätzgruben mit einem Öffnungswinkel von etwa 70° bilden, deren Durchmesser oder Querschnitts auf der aktiven Oberfläche einen von der Ätztiefe und/oder dem Öffnungswinkel abhängt.

Anschließend werden die Ätzgruben mit den Bondpads kontaktiert. Figur 1C zeigt eine Querschnittsansicht des Chips nach diesen Fertigungsschritten. Zur Herstellung der Kontaktierungen werden die Ätzgruben 17, sowie Bereiche der Oberseite 14 zwischen den Ätzgruben mit einem Metall beschichtet. Dadurch wird eine Metallschicht 18 gebildet, die sich auf den Wänden der Ätzgruben und auf leiterförmigen Bereichen zwischen den Ätzgruben befindet, wobei die Schicht die Bondpads zumindest teilweise überdeckt, um eine sichere Kontaktierung herzustellen. Als kontaktierendes Metall ist dabei beispielsweise Aluminium, Kupfer oder Nickel geeignet. Die metallbeschichteten Ätzgruben werden als nächstes mit einem Metall aufgefüllt, so daß die Gruben mit einer massiven leitenden Struktur 19 ausgefüllt sind.

Anschließend werden die Ätzgruben mit den Bondpads kontaktiert. Figur 1C zeigt eine Querschnittsansicht des Chips nach diesen Fertigungsschritten. Zur Herstellung der Kontaktierungen werden die Ätzgruben 17, sowie Bereiche der Oberseite 14 zwischen den Ätzgruben mit einem Metall beschichtet. Dadurch wird eine Metallschicht 18 gebildet, die sich auf den Wänden der Ätzgruben und auf leiterförmigen Bereichen zwischen den Ätzgruben befindet, wobei die Schicht die Bondpads zumindest teilweise überdeckt, um eine sichere Kontaktierung herzustellen. Als kontaktierendes Metall ist dabei beispielsweise Aluminium, Kupfer oder Nickel geeignet. Die metallbeschichteten Ätzgruben werden als nächstes mit einem Metall aufgefüllt, so daß die Gruben mit einer massiven leitenden Struktur 19 ausgefüllt sind.

Anders als anhand von Fig. 1C dargestellt, kann jedoch auch zuerst die Grube mit einem leitenden Material aufgefüllt werden und dann eine Leiterbahn von der Kontaktfläche 25 zur Auffüllung 19 gelegt werden; um einen elektrischen Kontakt herzustellen.

Als nächster Schritt wird die Oberseite 14 des Chip 1 zum Schutz der optisch sensitiven Schicht 11 mit einer optisch transparenten Abdeckung 20 versehen. Das Ergebnis dieser Herstellungsphase ist in Fig. 1D gezeigt. Neben dem Schutz der Halbleiterschaltkreise an der Chipoberseite 14 hat die Abdeckung außerdem die Funktion, den gesamten Aufbau mechanisch zu stabilisieren, was für die nachfolgenden Verfahrenschritte, insbesondere für das noch zu beschreibende Ausdünnen des Wafers, ausgehend von der passiven Seite, von Bedeutung ist. Die Abdeckung 20 wird bevorzugt mittels einer Epoxidharzschicht 21 auf den Chip aufgeklebt. Als Abdeckung ist beispielsweise eine Scheibe aus Glas oder vergleichbar transparentem Kunststoff geeignet.

Um eine Durchkontaktierung durch den Chip herzustellen, wird die Unterseite oder inaktive Seite 22 des Chips abgeschliffen, bis die leitenden Auffüllungen 19 der Ätzgruben 17 erreicht werden und sich dadurch Kontaktstellen bzw. Kontaktflächen 23 auf der Unterseite 22 des Chips bilden. Die Kontaktstelle kann hierbei nach einer von vielen möglichen Ausführungsformen beispielsweise eine Breite von ca. 50µm aufweisen. Hierbei wird davon ausgegangen, dass der Wafer eine Gesamtstärke von beispielsweise ca. 500µm hat, die Sacklochöffnung eine Eindringtiefe von etwas mehr als 200µm besitzt, so dass nach einem Ausdünnen des Substrats die Sacklochspitze bis auf eine Breit von 50µm freigelegt wird. Dieser Fertigungszustand ist in Fig. 1E abgebildet.

In diesem Zusammenhang sei hervorgehoben, dass es von Vorteil ist, wenn der Wafer so dünn wie möglich, insbesondere noch dünner als im obigen Beispiel, ausgedünnt wird, da hierdurch insbesondere der Lochöffnungsquerschnitt und die Lochtiefe sehr klein gehalten werden kann. Wobei die Stabilität des Wafers durch die Abdeckung bzw, dem Glas 20 gewährleistet wird.

Der Wafer liegt nun in einer Form vor, dass die Bondpads auf der passiven Seite des Wafers liegen. Er kann nun so weiter verarbeitet werden wie ein nicht-sensorischer Chip, z.B. mit allen bekannten Wafer Level Packaging (WLP) Verfahren.

Mit diesem Verfahren kann also die Palette der WLP für nicht sensorische Chips beachtlich erweitert werden. Die so mit verlegten Kontaktstellen (23) versehenen Chips können dann im gehäusten oder offen Zustand mit konventioneller SMT (Surface Mounted Technology) auf einem Board bzw. auf einer Leiterplatte kontaktiert werden.

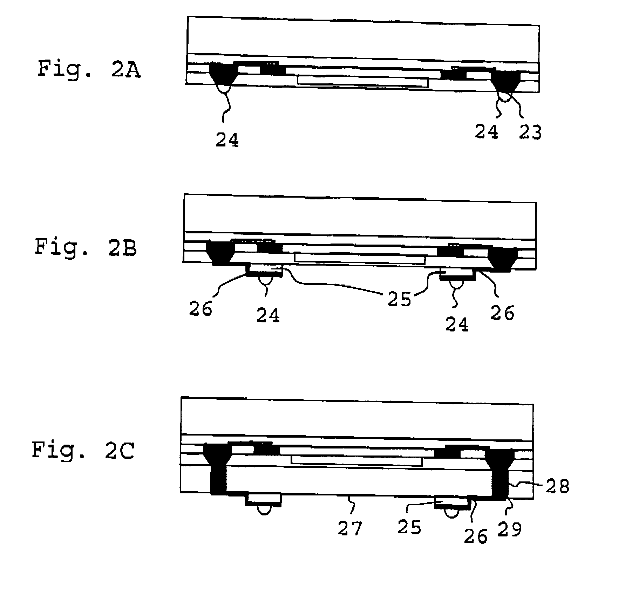

Insoweit sind aus den Figuren 2A bis 2E weitere mögliche Verfahrensschritte, die an den Verfahrensschritt nach den Figur 1E anschließen können zu entnehmen. Die Figuren 2A bis 2C zeigen auch insbesondere anhand von Querschnittsansichten durch einen Chip verschiedene Ausführungsformen des in Fig. 1E gezeigten Chip nach weiteren möglichen Bearbeitungsschritten, die als Vorbereitung vor dem Zusammenfügen von erfindungsgemäß hergestellten Chips zu einem Chipstapel geeignet sind.

Für ein mögliches Zusammenfügen des Chips mit einem darunterliegenden weiteren Baustein ist das Anbringen von Lötperlen zum Beispiel zweckmäßig, die mit den Kontaktflächen verbunden sind. In der einfachsten Form, die in Fig. 1A gezeigt ist, werden die Lötperlen 24 direkt auf die Kontaktflächen 22 aufgebracht. Eventuell kann auch eine Umverteilung oder Redistribution der Anschlußstellen auf der Unterseite des Chip vorgenommen werden. Dies kann beispielsweise dann notwendig werden, wenn der weitere Baustein, auf den der Chip gestapelt oder mit dem der Chip verbunden werden soll, die Kontaktflächen an Orten aufweist, die nicht mit den Kontaktflächen des Chips zusammenpassen. Eine Möglichkeit, umverteilte Kontakte an der passiven Seite des Chips anzubringen, ist in Fig. 2B gezeigt. Bei dieser Ausführung werden auf die Rückseite des Chip zunächst Bondpads 25 an den erwünschten Positionen angebracht. Anschließend werden Leiterbahnen von den Bondpads 25 zu den durch das Abschleifen und/oder Ätzen der Rückseite an den Auffüllungen 19 entstandenen Kontaktflächen 23 aufgetragen und Lötperlen 24 auf den Bondpads 25 aufgebracht.

Um dem Gehäusen des Chips bzw. der Montage des Chips in einem Gehäuse im Waferverband einen Schritt näher zu kommen wird auf der Unterseite 22 des Chips eine weitere Abdeckung 27 aufgebracht. Ein solcher zwischen zwei Abdeckungen 20 und 27 "gesandwichter" Chip ist aus Fig. 2C zu entnehmen. Da die Wärmeausdehnungskoeffizienten vom Deckglas 20 und zum Beispiel Halbleitermaterials des Chips oder Substrats 1 unterschiedlich sein können, kann es bei Erwärmung bzw. Abkühlung des Chips zu einem Bi-Metalleffekt kommen, so dass sich der Chip leicht biegt. In diesem Fall muss das unterseitige Material 27 (BCB, Plastik, Glas etc.) mechanisch dem oberen Material angepasst sein, und möglichst so, dass sich die Steifigkeit der Materialien, bestehend aus Dicke, E-Modul und Wärmeausdehnungskoeffizient gegenseitig kompensieren. Es ist also keinesfalls nötig, dass das obere Material 20 identisch mit dem unteren 27 sein muss.

Für den Fall, daß die Substrate der Chips, die aufeinandergesetzt werden sollen, unterschiedliche thermische Ausdehnungskoeffizienten oder auch im Betrieb unterschiedliche Temperaturen aufweisen, bietet sich ebenfalls der Einsatz einer Zwischenschicht zwischen den Chips an, welche durch ihre Flexibilität die zwischen den Substraten entstehenden Temperaturspannungen abbauen kann. Die in Fig. 2C gezeigte Ausführungsform kann auch eine für das Stapeln von Chips mit einer solchen flexiblen Zwischenschicht versehen sein. Bei dieser Ausführungsform des Verfahrens wird zunächst die Unterseite oder passive Seite 22 des Chip mit einer Zwischenschicht 27 versehen.

Beispielsweise kann bei der in Fig. 2C gezeigten flexiblen Abdeckung nach Vollendung des Verfahrensschritts gemäß Fig. 1E zunächst die Zwischenschicht 27 auf die Unterseite oder passive Seite 22 des Chips aufgeklebt werden, wobei die Schicht 25 Kanäle 28 aufweist, die in ihrer Anordnung in der Abdeckung mit den Kontaktflächen 23 zusammenpassen. Die Kanäle können ähnlich wie die Ätzgruben 17 mit einem Leiter 29 aufgefüllt werden. Ein geeignetes Verfahren besteht beispielsweise in einer galvanischen Abscheidung von Cu oder Ni. Alternativ kann auch ein leitendes Epoxid in die Ätzgruben gedrückt werden. Das Herstellen der Kontaktierungen mit Lötperlen 24 kann davon ausgehend dann in gleicher Weise erfolgen, wie im vorhergehenden Ausführungsbeispiel.

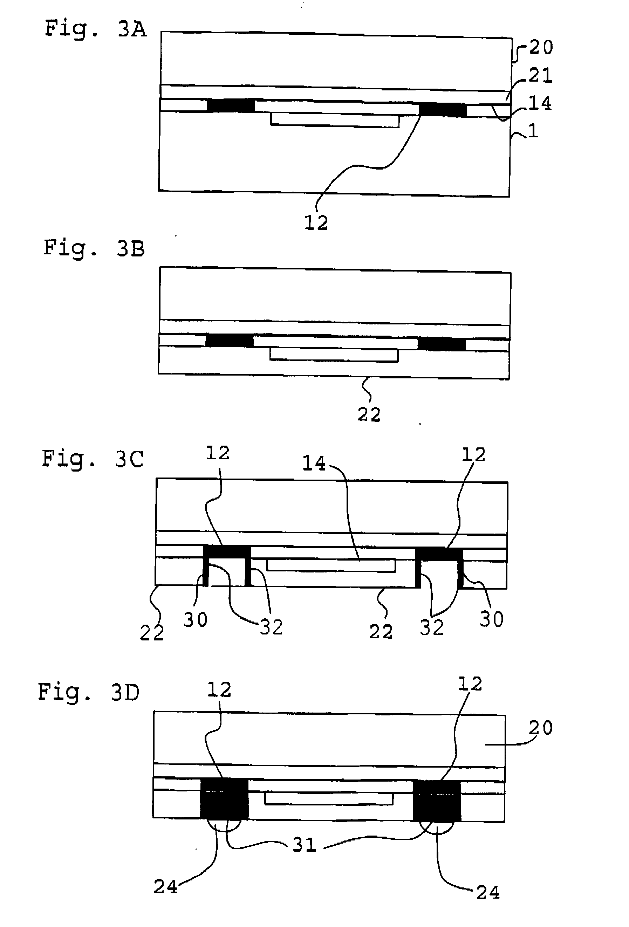

Gemäß dem im folgenden beschriebenen Ausführungsbeispiel wird die Oberseite 14 des wie in Fig. 1A vorbereiteten Chip 1 zunächst mittels einer Klebstoffschicht 21 mit einer transparenten Abdeckung 20 verklebt. Die Figuren 3A bis 3E zeigen ebenfalls anhand von Querschnittsansichten eines Chip-Bereich einer Halbleiterscheibe die Verfahrensschritte nach einer weiteren Ausführungsform des erfindungsgemäßen Verfahrens. Die in den Figuren 3A bis 3E gezeigten Verfahrensschritte gemäß dieses weiteren Ausführungsbeispiels der Erfindung sind ebenfalls geeignet, um das Zusammenfügen eines Chips zu einer mehrschichtigen integrierten Schaltungsanordnung vorzubereiten,

Demnach wird die Oberseite 14 des wie in Fig. 1A vorbereiteten Chips 1 zunächst über eine Klebstoffschicht 21 mit einer dünnen transparenten Abdeckung 20 verklebt. Diese Zwischenstufe des Verfahrens zeigt Fig, 3A. Der so präparierte Chip oder Wafer kann daraufhin wie anhand von Fig. 3B gezeigt ist, an seiner Unterseite 22 gefahrlos ausgedünnt werden, da der Aufbau durch den Verbund mit der Abdeckung ausreichende Stabilität gewonnen hat.

Die Dicke des Wafers sollte, wie bereits erwähnt, nach dem Ätzen und/oder Abschleifen so gering wie möglich sein.

Gemäß Fig. 3C werden danach in den Chip Ätzgruben 30 eingefügt, wobei im Gegensatz zum vorhergehenden Ausführungsbeispiel aber nun von der Unterseite 22 ausgehend geätzt wird, bis die Ätzgruben auf die auf der Oberseite 14 des Chips befindlichen Bondpads 12 stoßen. Die Metallschicht der Bondpads 12 wirkt dabei als Ätzstopp. Der Ätzprozess bzw. die Tiefenätzung erfolgt dabei vorzugsweise im Zusammenhang mit einer photolithographischen Strukturierung und einem anisotropen Trockenätzverfahren, z.B. dem sogenannten "ASE-Prozess" mit SF6. In der Regel verjüngen sich die so erzeugten Löcher nach innen oder weiten sich nach außen auf. Ferner verrundet ein so erzeugtes Sackloch am Sacklochende bzw. hier an den Bondpads.

Die Kanten oder Wandungen der Ätzgruben oder Lochöffnungen 30 werden anschließend über eine konforme Plasmaoxidabscheidung gegenüber dem Substrat 1 isoliert. Die Isolierschicht ist mit 32 gekennzeichnet. Eine solche Isolierung 32 ist grundsätzlich fakultativ. Sie ist jedoch dann vielfach notwendig, wenn das Substrat hoch dotiert ist, um Kurzschlüsse zu vermeiden. Als Verfahren kommen insoweit das auf SiH4 basierende LTO (Low Temperature Oxide)-Verfahren oder ein auf TEOS-Oxide (TEOS, Tetra-Ethylen-Ortho-Silikat) beruhende Verfahren in Betracht. Die Plasmaoxidabscheidung ist in der Regel gefolgt von einem Rückätzschritt, um unter anderem die Rückseite der Bondpads 12 wiederum freizulegen. Im Anschluss daran wird, wie aus Figur 3D zu entnehmen ist, die Ätzgruben oder Lochöffnungen 30 mit einem leitfähigen Material aufgefüllt. Die Füllungen 31 kann wiederum durch galvanisches Abscheiden von Metall in der Ätzgrube durchgeführt werden oder durch ein Auffüllen der Öffnungen mit einem Leitkleber (Leit-Epoxid) vermittels der Siebdruck/Rakeltechnik.

Mit den so hergestellten Füllungen 31 im Substrat kann nun analog zum vorhergehenden Ausführungsbeispiel weiter verfahren werden. So können die Lötperlen 24 wie in Fig. 2A gezeigt, direkt auf die Auffüllungen 31 aufgebracht werden und in Analogie zu Fig. 2B mit einer Redistribution versetzt werden. Ferner ist es möglich entsprechend zu Fig. 2C auf der Rückseite 22 eine weitere Abdeckung aufzubringen und die über die Füllungen 31 geschaffenen Kontaktstellen durch die Abdeckung hindurch nach außen zu kontaktieren.

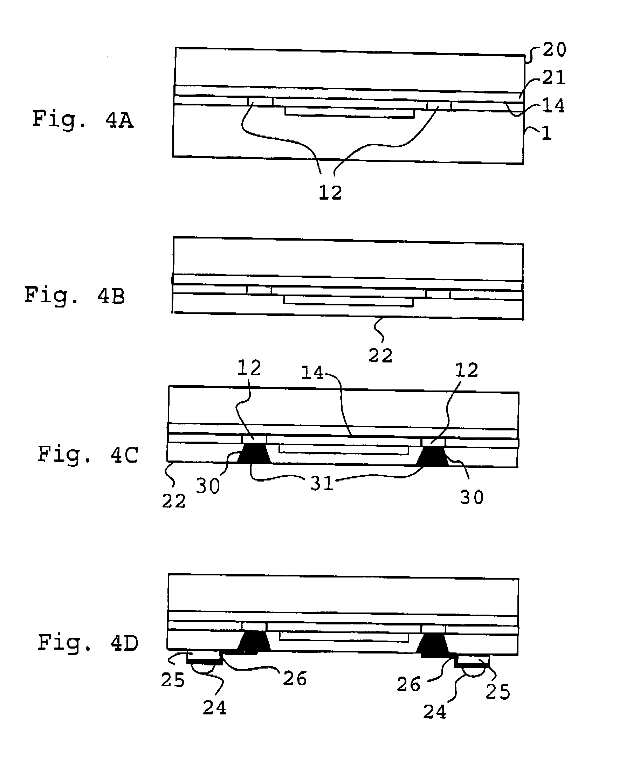

Die Fig. 4A bis 4D zeigen eine solche Variante des anhand der Figuren 3A bis 3D dargestellten Verfahrens mit einer Redistribution der Anschlüsse analog zu der in Fig. 2C gezeigten Ausführung, wobei die Bondpads 25 auf denen die Lötperlen 24 aufgebracht werden, lateral versetzt von den Durchkontaktierungen angeordnet und über aufgetragene Leiterbahnen 26 mit den Durchkontaktierungen verbunden sind. Das Aufbringen der Isolierschicht 32, wie sie in den Fig. 3C und 3D gezeigt ist, wurde der Übersichtlichkeit halber weggelassen. Die Ätzgruben 30 zeigen aufgrund des anisotropen Ätzens eine zur ersten Oberfläche 14 konisch zulaufende Form.

Anstelle von aufgefüllten Ätzgruben können die Bereiche 31 in den Figuren ebenso leitende dotierte Bereiche repräsentieren, die ebenfalls eine Durchkontaktierung durch das Substrat herstellen.

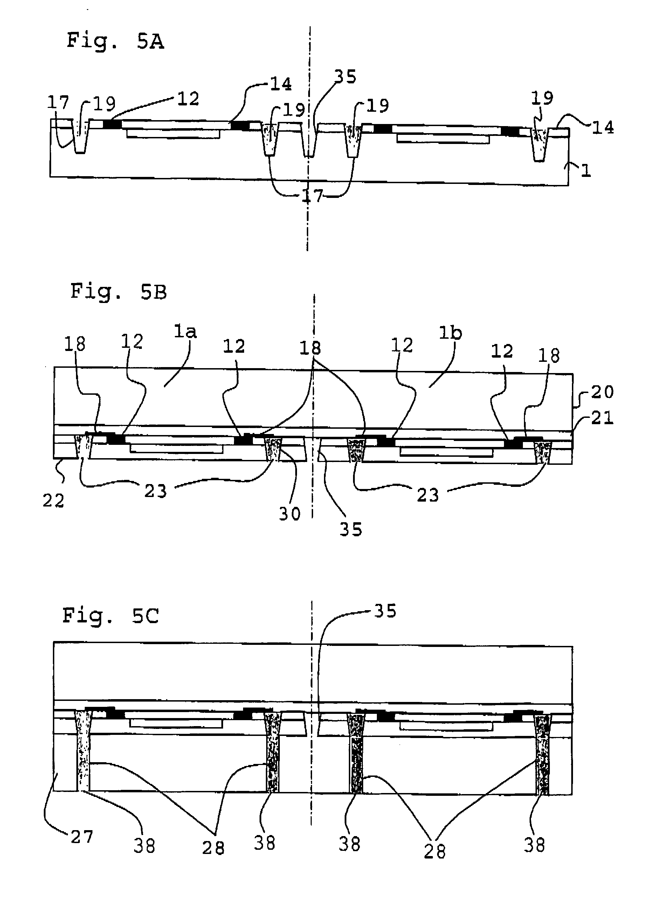

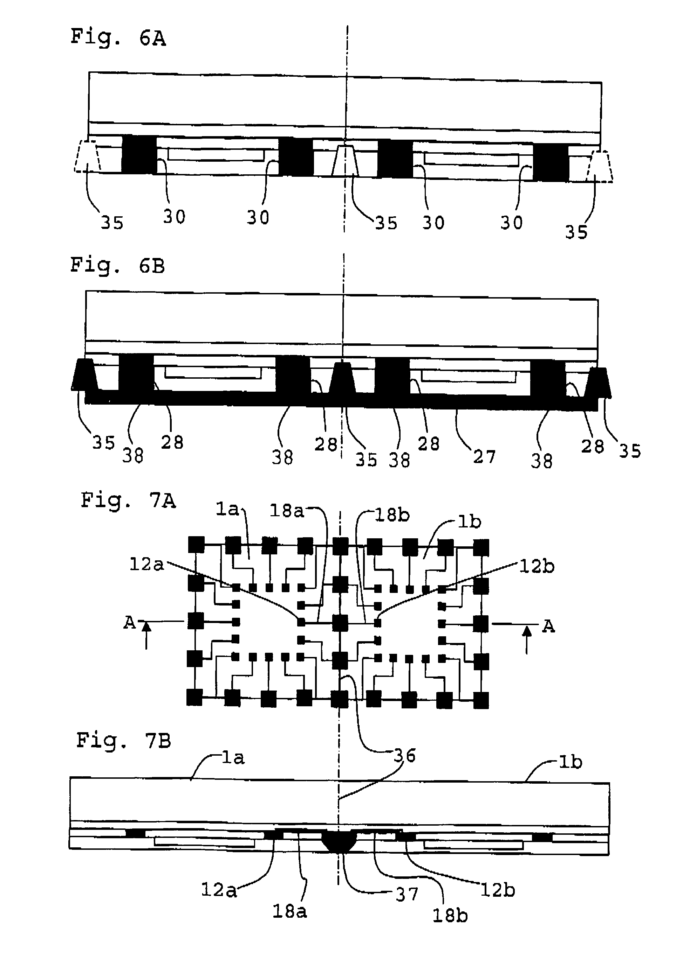

Aus den Figuren 5A bis 5C ist im Hinblick auf ein vollständiges Gehäusen der Chips 1a und 1b im Waferverband 1 mögliche weiter Verfahrensschritte aufgezeigt. Hierzu werden zum einen die bereits oben dargestellten Verfahrensschritte zur Durchkontaktierung und Herstellung der Kontakflächen 23 vorgenommen. Darüber hinaus werden allerdings noch zusätzlich durch geeignete Ätzprozesse Gräben entlang der Trennlinien auf dem Wafer benachbarter Chips erzeugt. Durch ein solches Erzeugung von Gräben zwischen den Chips ergibt sich die Möglichkeit zur lateralen Versiegelung der Chips mit z.B. Epoxidharz, so dass kein blankes Silizium mehr vorliegt. Die aktive Vorder und die passive Rückseite des Wafers 1 bzw. der Chips 1a und 1b werden wie gehabt mit Abdeckungen beschichtet. Die auf der Vorderseite vorzugsweise mit einem Glas 20 und die auf der Rückseit vorzugsweise auch mit einem Glas oder einer photostrukturierbaren Schicht 27 (z.B. BCB oder Benzocyclobuten) beschichtet, wobei letzteres auch in die Gräben 35 fließt. Hierzu sei beispielhaft auch auf die Figuren 6A und 6B verwiesen. Nach dieser Ausführungsform wurden die durch Schleifen oder Ätzen die Gräben 35 entsprechend den Lochöffnungen von der Rückseite des Wafers 1 her in das Substrat 1 eingebracht (Fig. 6A), Wird nun wie besprochen und wie in Fig. 6B dargestellt auf die Rückseite eine BCB-Schicht aufgebracht, so werden in isolierender Form auch die Gräben 35 mit BCB befüllt und eine laterale Abdichtung bewirkt. An den Gräben 35 erfolgt später das Dicing, d.h. das Zertrennen des Wafers in einzelne Chips.

Ebenso, wie auch das Herstellen der Ätzgruben für die leitenden Kanäle können auch die Gräben 35 mit einem anisotropen Trockenätzverfahren wie etwa mittels eines ASE-Prozesses oder durch anisotropes Ätzen mit KOH-Lauge erzeugt werden. Allgemein kann das Ätzen der Ätzgruben, sowie der Trenngräben 35 auch durch eine Kombination verschiedener Ätzverfahren durchgeführt werden. So kann eine Ätzgrube oder ein Trenngraben beispielsweise in einem ersten Schritt mittels Nassätzen und dann weiter mittels anisotropem Trockenätzen hergestellt werden. Allgemein kann sowohl das gleiche Ätzverfahren, als auch unterschiedliche Ätzverfahren oder Kombinationen der Ätzprozesse für das Herstellen von Gräben und Ätzgruben angewendet werden. Eine mögliche Ausführungsform sieht zum Beispiel das nasschemische Vorätzen der Trenngräben und dann daran anschließend das gemeinsame Ätzen von Oberflächenbereichen für Trenngräben und leitende Kanäle mittels anisotropem Trockenätzen vor. Durch die Kombination verschiedener Ätzprozesse kann so die Form, wie etwa die Wandsteilheit, als auch die Größe und Tiefe der geätzten Strukturen vorteilhaft gesteuert werden. Aus den Figuren 7A und 7B ist eine weitere Ausführungsmöglichkeit für eine erfindungsgemäße Durchkontaktierung zu erkennen. Fig. 7B zeigt hierzu den Querschnitt in A-Richtung. Die Durchkontaktierungskanäle 17 bzw. 19 liegen hier entlang der Chip-Trennlinien 36 auf dem Wafer. Auf diese Weise ist es einfach möglich über eine Ätzgrube 17 gleich zwei oder mehrere Bondpads 12a und 12b von benachbarten Chips 1a und 1b durch geeignete Redistribution der Kontaktstellen zur Durchkonktierungstelle 19 zu kontaktieren. Hierzu wurden nach einer elektrischen Isolierung der Wandungen der Sacklochöffnung in diese Kontaktbahnen 18 verlegt. Jedoch wurden im Gegensatz zum Prozess nach den Figs 1A bis 1E die Sacklochöffnung nicht zusätzlich noch mit einem leitfähigen Material ausgegossen, sondern mit einem Isolierstoff 37. Dies hat den positiven Effekt, dass nach dem Zertrennen des Wafers entlang der Trennlinie bzw. entlang der Durchkontaktierungstellen die vereinzelten Chips lateral nach außen isoliert sind.

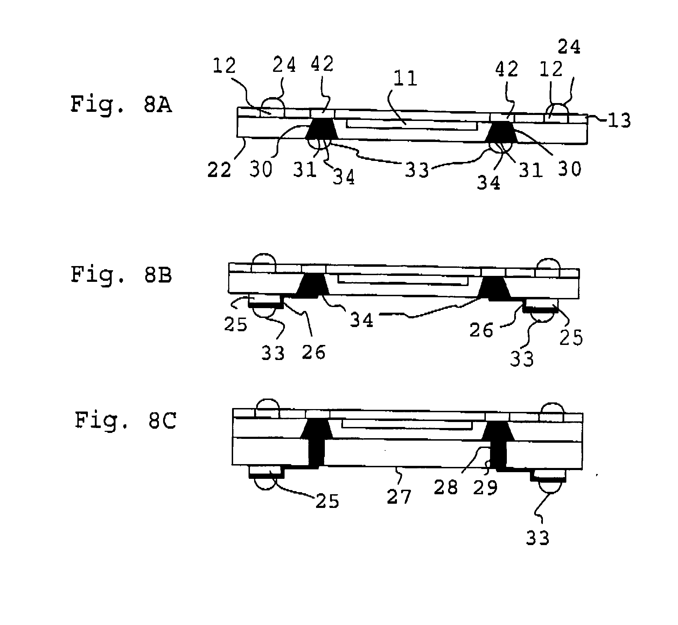

Ähnlich der oben ausgeführten Vorbereitung des oberen Chips werden die darunterliegenden Bausteine präpariert. Mögliche Ausführungen zeigen die Querschnittsansichten der Figuren 8A bis 8C. Die sich im Chipstapel unter dem obersten Baustein befindlichen Chips benötigen zwei Sätze oder Arten von Bondpads, von denen ein Satz dazu dient, den Kontakt mit dem darüberliegenden Chip herzustellen und der andere Satz dafür vorgesehen ist, die Verbindung mit dem darunterliegenden Chip oder, für den Fall, daß der Chip der unterste des Stapels ist, die Verbindung mit der Platine oder einer vorgesehenen Unterlage herzustellen.

Der Chip wird dazu auf der passiven Seite soweit ausgedünnt, wie es die Stabilitätsanforderungen während des Herstellungsprozesses erlauben. Befinden sich die Chips im Waferverband, so kann ein freitragender Wafer dabei auf etwa 200µm bis 300µm ausgedünnt werden. Fig. 8A zeigt eine erste mögliche Ausführung eines solchen Chips 2, bei dem es sich beispielsweise um einen Speicherbaustein handeln kann. Der Chip 2 weist ebenso wie der oben beschriebene Chip 1 eine unter einer Passivierungsschicht 13 liegende aktive Schicht 11 auf, in welcher sich die Bauelemente des integrierten Schaltkreises befinden. Auf einem ersten Satz von Bondpads 12 werden Lötperlen 24 aufgebracht, die später zur Verbindung mit dem darüberliegenden Chip, wie etwa dem obersten Chip 1 benutzt werden,

In die Unterseite 22 werden gemäß der Ausführungsform nach Fig. 8A Ätzgruben 30 hineingeätzt, welche bis auf die Bondpads 42 des zweiten Satzes von Kontaktflächen hinaufreichen. Die dadurch gebildeten Kanäle werden ebenfalls wie beim obersten Chip 1 mit einem Leiter 31 aufgefüllt. Auf die an der Unterseite 22 des Chip durch die Auffüllung entstehenden Kontaktflächen werden zur Kontaktierung der nächsten Ebene des Chipstapels wieder Lötperlen 33 aufgeschmolzen.

Für den Fall, daß keine weitere Ebene des Chipstapels folgen soll, daß also der Chip 2 der Unterste des Stapels ist, kann das für die Lötperlen 33 verwendete Lot vorteilhaft einen niedrigeren Schmelzpunkt aufweisen, wie das für die andere Lötperlen 24 verwendete Material, Damit läßt sich der zusammengefügte Chipstapel auf einer Platine oder einer sonstigen Unterlage durch Aufschmelzen der Lötperlen 33 befestigen, ohne daß die anderen Lötperlen 24 schmelzen.

Fig. 8B zeigt eine andere Ausführungsform, bei der analog zu der in Fig. 3E gezeigten Anordnung die Anschlußkontakte bestehend aus Bondpads 25 mit Lötperlen 33 umverteilt wurden und mit Leiterbahnen 26 mit den Kontaktflächen 34 der Auffüllung 31 verbunden sind.

In Fig. 8C ist eine weitere Ausführungsform des Chip 2 gezeigt, bei dem ähnlich zu Fig. 2C eine untere Abdeckung 27 aufgebracht wurde, die als schützende Verpackung und/oder flexible Zwischenschicht fungieren kann, um Temperaturspannungen zwischen den Chips aufzufangen. Der Chip ist wie im vorhergehenden Beispiel und wie in Fig. 2C mit umverteilten Kontakten, bestehend aus Bondpads 25 mit Lötperlen 33 dargestellt.

Zur Durchkontaktierung der in der Abdeckung 27 befindlichen Kanäle 28 bis zur Unterseite der Abdeckung werden auch hier die Kanäle 28 mit einer leitenden Füllung 29 aufgefüllt. Hierbei kann es zweckmäßig sein, die Redistribution der Kontakte so vorzunehmen, daß die auf der Unterseite und Oberseite der Chips liegenden Kontakte in ihren lateralen Positionen aufeinanderpassen. Hierdurch lassen sich mehrere Chips 2 beliebig hinsichtlich der Reihenfolge und Anzahl in einem Chipstapel miteinander kombinieren. Dies kann beispielsweise vorteilhaft sein, wenn ein solcher Chipstapel mehrere Speicherbausteine umfaßt. Ferner können hierdurch ohne unnötig hohen Aufwand mehrere verschiedene Varianten, die sich nur in der Anzahl gestapelter Speicherbausteine unterscheiden, aus den gleichen Einzelbausteinen gefertigt werden.

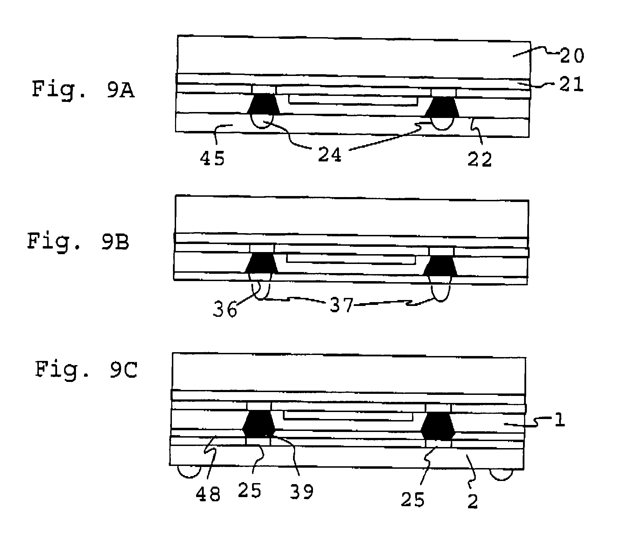

Die Figuren 9A bis 9C zeigen anhand von Querschnitten die Schritte eines Ausführungsbeispiels, wie der oberste Chip mit einem darunterliegenden Chip zu einem Stapel zusammengefügt werden kann.

Ausgehend von einem wie beispielsweise in Fig. 3D abgebildeten optischen Chip, der mittels einer Klebstoffschicht 21 mit einer Abdeckung 20 verbunden ist und an den auf die Unterseite durchgeführten Kontakten Lötperlen 24 aufweist, wird der Baustein an seiner Unterseite 22 mit einer Klebstoffschicht 45 überzogen, wie in Fig. 9A gezeigt ist. Für diese Schicht kann ein thermoplastischer Kunststoff verwendet werden. Die Schichtdicke wird dabei so gewählt, daß die Lötperlen 24 vollständig überdeckt werden.

Anschließend wird die Schicht 45 abgeschliffen, bis die Lötperlen 24 hervortreten und zusammen mit der Schicht plangeschliffen werden, so daß, wie in Fig. 9B dargestellt ist, ebene Kontaktflächen 36 entstehen. Auf diese Flächen werden erneut Lötperlen 37 aufgesetzt.

Fig. 9C zeigt den mit einem weiteren Chip 2 verbundenen optischen Chip 1. Zum Verbinden wird das Lot der Lötperlen auf den Bondpads 25 der beiden Chips durch Erhitzung aufgeschmolzen und die Lötperlen auf den Kontaktflächen der beiden Chips 1, 2 vereinigen sich zu einer Lötverbindung 39. Durch das Erhitzen erweicht auch die thermoplastische Kunststoffschicht 48 und verklebt die beiden Bausteine.

Durch die Oberflächenspannung des geschmolzenen Lots tritt beim Aufeinandersetzen der Chips außerdem ein Selbstjustierungseffekt ein. Aufgrund der Oberflächenspannung werden die Chips in eine Richtung so gezogen, daß der laterale Abstand der miteinander über das Lot verbundenen Kontaktflächen 25 zwischen den Chips minimal wird.

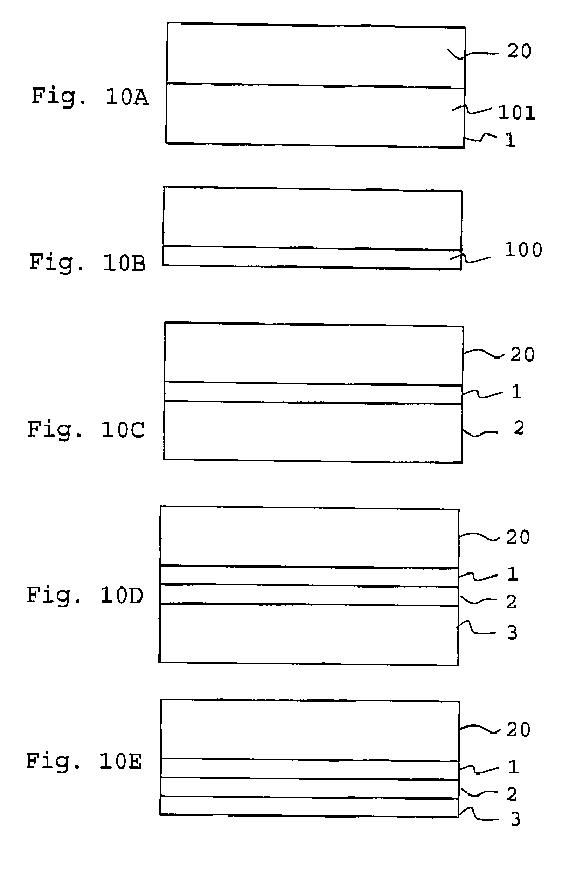

Ein weiteres Ausführungsbeispiel des erfindungsgemäßen Verfahrens wird im folgenden anhand der schematischen Querschnitte der Figuren 10A bis 10E erläutert. Dieses Ausführungsbeispiel basiert auf einem sukzessiven Befestigen mit anschließendem Ausdünnen der Wafer oder Chips, wobei der Verbund der bereits zusammengefügten Elemente dem zuletzt angefügten Baustein, bzw. Wafer zusätzliche Stabilität verschafft, so daß dieser weiter ausgedünnt werden kann.

Gemäß Fig. 10A wird zunächst wieder eine Abdeckung 20 auf dem ersten oder obersten Chip 1 befestigt. Das Substrat 100 des Chip 1 wird anschließend ausgedünnt (Fig. 6B) und Durchkontaktierungen gemäß den bezüglich der Figuren 3A bis 3E beschriebenen Verfahren erzeugt (nicht gezeigt). Daraufhin wird wie in Fig. 6C gezeigt, der nächste Chip 2 aufgesetzt und unter Verbindung der Durchkontaktierungen auf dem ersten Chip 1 mit zugehörigen Anschlüssen auf dem weiteren Chip 2 befestigt. Der aufgesetzte Chip 2 weist zu diesem Zeitpunkt noch keine Ätzgruben, Löcher oder dotierte Bereiche für die Durchkontaktierung auf. Da der aufgesetzte Wafer oder Chip nun aber fest mit dem ersten Chip verbunden ist, besitzt der aufgesetzte Chip 2 durch den Verbund mit ersten Chip 1 und der Abdeckung 20 eine mechanisch stabile Unterlage und kann gefahrlos ebenso weit wie der erste Chip 1 des Stapels ausgedünnt werden.

In einem nächsten Schritt werden dann in dem aufgesetzten Chip 2, wie anhand der Figuren 3A bis 3D, beziehungsweise 4A bis 4D oder der Figuren 8A bis 8C beschrieben wurde, Durchkontaktierungen erzeugt, und kann ein weiterer Chip 3 oder Wafer aufgesetzt werden. Dieser Fertigungszustand ist in Fig. 10D dargestellt.

Diese Schritte können mit beliebig vielen Bauelementen einzeln oder im Waferverband wiederholt werden, so daß ein Chipstapel entsteht, wie er schematisch in Fig. 10E mit drei aufeinandergesetzten Chips 1, 2 und 3 gezeigt ist. Die Chips können dabei sowohl direkt als auch über isolierende und/oder flexible Zwischenschichten miteinander verbunden sein.

Alle bisher beschriebenen Schritte können im Waferverband durchgeführt werden. Es lassen sich damit auch zusätzlich verschiedene Verpackungsverfahren auf Waferebene ("Wafer Level Packaging") zumindest teil- oder einzelschrittweise in das erfindungsgemäße Verfahren integrieren.

Darüber hinaus läßt sich auch das Bonden oder Zusammenbonden, bzw, das Verbinden der Chips zu einem Stapel im Waferverband bewerkstelligen. Voraussetzung hierfür ist, daß die Chips auf verschiedenen Wafern in gleicher Weise lateral angeordnet sind, so daß die Chips eines Stapels beim Aufeinandersetzen der Wafer aufeinander zu liegen kommen.

Die aufeinandergestapelten Chips im Waferverband können dann anschließend mit einer Dicing-Säge abgetrennnt werden.

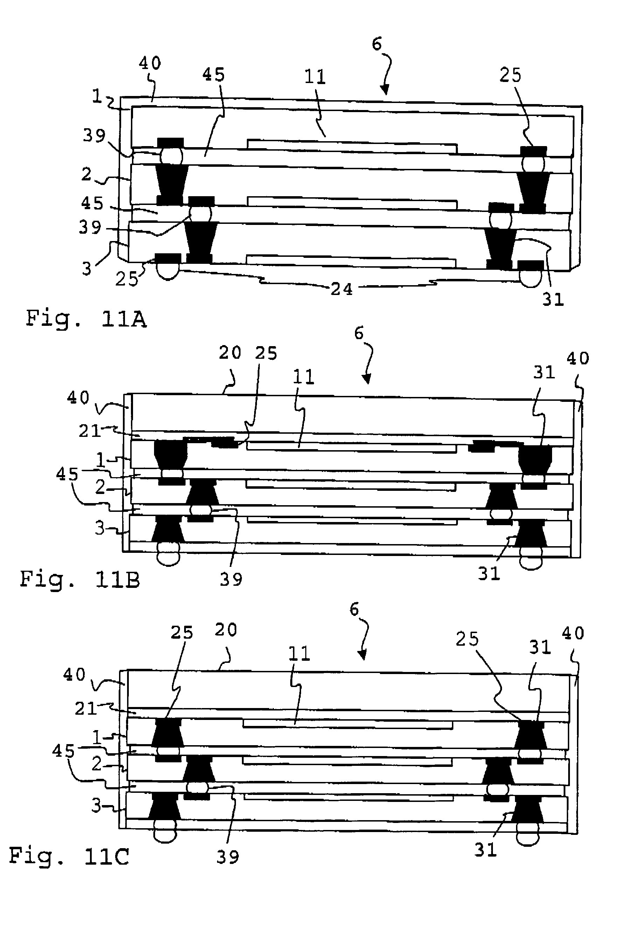

Die Figuren 11A bis 11C zeigen wie oben beschrieben hergestellte Ausführungsformen von Chipstapeln 6 mit drei Schichten. Im einzelnen zeigt Fig. 11A eine Ausführungsform eines Chipstapels 6, bei dem der oberste Chip 1 kein optischer Baustein ist, sondern eine andere integrierte Schaltung umfaßt, wobei die Seite mit der aktiven Schicht 11 dem darunterliegenden Baustein 2 zugewandt ist. Demzufolge ist in dieser Ausführungsform eine Durchkontaktierung des obersten Chips nicht notwendig.

Die darunterliegenden Chips 2 und 3 hingegen weisen Durchkontaktierungen auf, die gemäß dem erfindungsgemäßen Verfahren hergestellt wurden. Die leitenden Auffüllungen 31 der Durchkontaktierungen der Chips 2 und 3 sind über Lötverbindungen 39 mit korrespondierenden Bondpads 25 des jeweiligen darüberliegenden Chips 1, bzw. 2 verbunden. Zwischen den Chips befinden sich Zwischenschichten 45, welche die Chips miteinander verbinden und als flexible Ausgleichschicht zum Abbau von zwischen den Chips entstehenden Temperaturspannungen dienen kann.

Die Unterseite des untersten Chips 3 des Chipstapels 6 ist hingegen in dieser Ausführungsform nicht versiegelt. Der Chipstapel 6 kann dadurch wie bei der sogenannten "Flip-Chip" Technik weiterverwendet werden und mittels Auschmelzen der Lötperlen 24 mit Kontaktflächen des vorgesehenen Substrats, wie etwa mit einer Platine verbunden werden. Nachdem der im Waferverband zusammengesetzte Chipstapel vom Stapel der Wafer abgetrennt wurde, kann der so entstandene mehrschichtige integrierte Baustein oder Chipstapel 6 mit einer Epoxidharzummantelung 40 versiegelt werden.

In Fig. 11B ist eine mögliche Ausführungsform eines Chipstapels 6 mit einem optischen Chip als oberstes Element gezeigt.

Der optische Chip 1 ist in diesem Fall gemäß der in den Figuren 1A bis 1E gezeigten Verfahrensschritte vorbereitet, bei denen das Durchätzen des Substrats von der Oberseite, bzw. der aktiven Seite her erfolgt, woraufhin auf den Wafer anschließend über eine optische Epoxidharzschicht 21 eine transparente Abdeckung 20 aufgebracht wird. Der Chip wird anschließend mit den gemäß der Beschreibung in Bezug auf die Figuren 40A bis 40C vorbereiteten unteren Chips 2 und 3 zusammengebondet. Das Bonding kann dabei wie bezüglich der Figuren 9A bis 9D beschrieben durchgeführt werden.

In dieser beispielhaften Ausführungsform ist auch die Unterseite des Chipstapels mit einer Abdeckung versehen, die als flexible Zwischen- oder Ausgleichsschicht zwischen dem untersten Chip des Stapels und der Unterlage einerseits und/oder als schützende Verpackung andererseits dienen.

Fig. 11C zeigt ein Variante des in Fig. 11B dargestellten Chipstapels. Die in Fig. 11C gezeigte Variante stellt dabei eine besonders bevorzugte Ausführungsform dar. Diese Ausführungsform unterscheidet sich von der in Fig. 11B gezeigten Ausführungsform dahingehend, daß hier die leitenden Kanäle 31 nicht von der Seite her, welche die aktive Schicht 11 aufweist, sondern bei allen durchkontaktierten Chips des Chipstapels von der gegenüberliegenden Seite her eingefügt wurden. Der Übersichtlichkeit halber sind dabei die in den Figuren 3C und 3D gezeigten Isolierschichten 32 weggelassen.

Die anhand der Figuren 11A bis 11C beschriebenen mehrschichtigen integrierten Schaltungsanordnungen, die zusätzlich zumindest teilweise schützend abgedeckt oder mit einer Gehäusung umgeben sind, stellen gehäuste Multipackages dar. Die Gehäusung besteht dabei aus allen Teilen des Multipackages, welche die Chips abdecken, wie beispielsweise die transparente Abdeckung 20, die Epoxidharzummantelung 40 oder eine untere Klebstoffschicht 45.

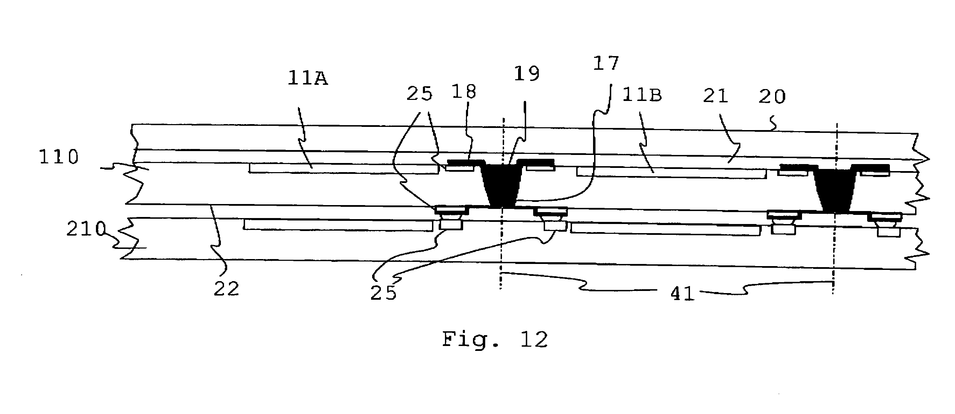

Fig. 12 zeigt einen Querschnitt eines Ausführungsbeispiels, bei dem sich mehrere Chips, die auf einem Wafer im Waferverband zusammenhängen, eine Durchkontaktierung teilen. Die Chips für die oberste Position im Stapel, die im Waferverband auf einem Wafer 110 hergestellt worden sind, werden gemäß dem anhand der Figuren 1A bis 1E erläuterten Verfahren präpariert. Hier wird jedoch eine Metallschicht 18 aufgebracht, welche Kontaktflächen 25A, 25B mit der Ätzgrube 17 verbindet, wobei die Kontaktflächen 25A und 25B an die aktiven Schichten 11A, 11b zweier verschiedener Bausteine im Waferverband angeschlossen sind.

Auf der Unterseite 22 werden die Kontakte wie in Figur 2B oder 2C gezeigt, umverteilt. Die umverteilten Kontakte werden beim Verbinden der Wafer 110, 120 mit den Kontaktflächen 25 der Bausteine des jeweils darunterliegenden Wafers verbunden. Die Wafer können nach dem Verbinden entlang von Trennlinien 41 vom Waferverband abgetrennt werden, die mittig durch die gemeinsame Durchkontaktierung verläuft. Nach dem Trennen des Chipstapels ergibt sich daraus keine Durchkontaktierung, sondern eine Kontaktierung, die um den Rand des Substrats eines Chips im Chipstapel herum läuft.

Ein nach einem der oben beschriebenen Ausführungsbeispiele hergestellter Chipstapel kann nach der Fertigstellung mit einem bekannten Verfahren weiterverarbeitet werden. So kann der Chipstapel, bzw. die mehrschichtige Halbleiteranordnung mit Verfahren der SMD-Technik direkt mit einer Platine verbunden werden oder in ein geeignetes Gehäuse für SMD-Verfahren oder Through-Hole-Techniken eingegossen werden.

## Patentansprüche

**1.** Verfahren zum Herstellen von elektrischen Kontaktverbindungen in einem Halbleiter-Wafer (1), wobei der Wafer eine Oberseite, eine Unterseite, zumindest einen Anschlußkontakt (25) auf der Oberseite und auf der Oberseite (14) zumindest ein optisch aktives Bauelement umfasst, wobei
- der Wafer vor dem Zertrennen ausgedünnt wird, und wobei
- wenigstens ein Kontaktkanal in dem ausgedünnten Wafer erzeugt wird, welcher ein Loch (17) umfasst, welches
- von der Unterseite bis zum Anschlußkontakt (25) auf der Oberseite reicht, und wobei das Loch (17)
- mit einem Isolator zur elektrischen Isolation des Lochs (17) zum Wafer versehen und
- mit einem Metall beschichtet wird.

**2.** Verfahren nach Anspruch 1, wobei vor dem Ausdünnen eine transparente Abdeckung (20) auf der Oberseite (14) des Wafers (1) befestigt wird.

**3.** Verfahren nach vorstehendem Anspruch, bei welchem die transparente Abdeckung (20) mit der Oberseite verklebt wird.

**4.** Verfahren gemäß einem der beiden vorstehenden Ansprüche, **dadurch gekennzeichnet, dass** die transparente Abdeckung (20) mit der Oberseite mit einem Epoxidharz verklebt wird.

**5.** Verfahren nach einem der Ansprüche 1 bis 4, **dadurch gekennzeichnet, daß** auf der Unterseite des Wafers (1) zumindest eine Kontaktfläche (25) aufgebracht wird, die mit der leitenden Kanal elektrisch verbunden ist.

**6.** Verfahren nach einem der Ansprüche 1 bis 5, weiter umfassend das Zertrennen des Wafers.

**10.** Verfahren nach einem der vorstehenden Ansprüche, **dadurch gekennzeichnet, daß** das Metall auf dem Isolator auf der Lochwandung abgeschieden wird.

**11.** Verfahren nach einem der vorstehenden Ansprüche, **dadurch gekennzeichnet, dass** der Wafer (1) auf weniger als 200 µm ausgedünnt wird.

**12.** Verfahren nach Anspruch 42, bei welchem das zumindest eine Loch durch Einätzen in den Wafer hergestellt wird.
